# EUROPÄISCHE PATENTSCHRIFT

(11) **EP 3 748 854 B1**
(45) Veröffentlichungstag und Bekanntmachung des Hinweises auf die Patenterteilung: **12.08.2026**
(21) Anmeldenummer: 20183059.3
(22) Anmeldetag: 12.02.2014
(51) Int. Cl.: H03K 17/955

(54) **VEREINFACHTE KAPAZITIVE SENSOREINHEIT**
SIMPLIFIED CAPACITIVE SENSOR UNIT
UNITÉ DE DÉTECTION CAPACITIVE SIMPLIFIÉE

(30) Priorität: 12.02.2013 DE 102013101374
(43) Veröffentlichungstag der Anmeldung: 09.12.2020
(62) Dokumentnummer(n) der früheren Anmeldung(en) nach Art. 76 EPÜ: 14704149.5 / 2 957 034
(73) Patentinhaber: Huf Hülsbeck & Fürst GmbH & Co. KG, 42551 Velbert (DE)
(72) Erfinder: Muzzetto, Mario, 42697 Solingen (DE)
(74) Vertreter: Bals & Vogel Patentanwälte PartGmbB

(56) Entgegenhaltungen:
- DE-A1- 102010 060 364
- US-A1- 2009 295 410

## Beschreibung

Die vorliegende Erfindung ist auf eine Sensoreinheit zum berührungslosen Betätigen eines Stellelementes, insbesondere einer Klappe eines Kraftfahrzeuges oder dergleichen, gemäß dem Oberbegriff von Anspruch 1 gerichtet. Hierbei ist die Sensoreinheit mit zumindest einem kapazitiven Sensorelement ausgestattet, wobei das Sensorelement einen Draht aufweist, der an dem Trägerelement angeordnet ist. Des Weiteren ist die vorliegende Erfindung auch auf ein Sicherheitssystem zum (insbesondere) berührungslosen Öffnen und/oder Schließen einer Klappe eines Fahrzeuges oder dergleichen gemäß dem Oberbegriff von Anspruch 14 gerichtet. Außerdem betrifft die Erfindung auch ein Verfahren zur Herstellung einer Sensoreinheit zum berührungslosen Betätigen eines Stellelementes, insbesondere einer Klappe eines Fahrzeuges oder dergleichen, nach dem Oberbegriff von Anspruch 15.

Aus dem Stand der Technik sind derartige Sensoreinheiten hinlänglich bekannt und dienen dazu, z. B. bei einem Fahrzeug die Heckklappe berührungslos öffnen zu können. In der Druckschrift DE 10 2010 049 400 A1 wird eine derartige Sensoreinheit offenbart. Zu diesem Zweck werden bei der entsprechenden Sensoreinheit kapazitive Sensoren als Näherungssensoren eingesetzt, die zweckmäßigerweise eine breitflächige Elektrode aufweisen. Breitflächig ausgestaltete Elektroden weisen dabei den Vorteil auf, dass das Sensorfeld optimal ausgestaltet ist, um eine Annäherung eines Objektes, insbesondere in Form eines Beines eines Benutzers durch eine kapazitive Änderung bei dem Sensor erkennen zu können. Somit hat es sich als vorteilhaft herausgestellt, wenn die kapazitiven Sensoren über eine gewisse Breite verfügen, um das Messergebnis zu verbessern. Aus der Druckschrift DE 10 2010 038 705 A1 geht ebenfalls eine Sensoreinheit hervor, die dazu dient, die Heckklappe eines Fahrzeuges berührungslos anzusteuern. In dieser Schrift wird ebenfalls erläutert, wie eine Kollisionsverhinderung mit einem Objekt, welches im Bereich der Klappe liegt, zu erreichen ist.

Auch ist aus der Druckschrift DE 10 2010 060 364 A1 eine Sensoreinheit für die Betätigung der Heckklappe bei einem Fahrzeug bekannt, die über zwei getrennte kapazitive Näherungssensoren verfügt, um die Bewegung eines Beines, insbesondere den Bewegungsablauf, messtechnisch erfassen zu können. Diese Sensoreinheit steht in Kontakt mit einem Sicherheitssystem des Fahrzeuges, sodass durch die Sensoreinheit auch eine Authentisierung eines ID-Gebers von einem Benutzer eingeleitet werden kann.

Die bisher aus dem Stand der Technik bekannten Sensoren für derartige Sensoreinheiten verfügen somit über eine gewisse Breite und Länge, um einen optimalen Messbereich zu erreichen. Hierfür werden i. d. R. flache, elektrisch leitende Bänder oder Folien als Sensoren verwendet. Da diese jedoch in einem kritischen Bereich bei einem Fahrzeug, insbesondere an der Innenseite des Stoßfängers, der starken Verschmutzungen, Steinschlag, Wasserstrahlen und dergleichen ausgesetzt ist, angeordnet sind, müssen diese Sensoren geschützt vor den äußeren Einflüssen untergebracht werden. In der Praxis hat es sich hierbei gezeigt, dass leider nicht ausreichend geschützte Sensoren durch Spritzwasser und Steinschlag beschädigt worden sind, was dazu führte, dass die Sensoren funktionsunfähig werden.

Es ist Aufgabe der vorliegenden Erfindung eine Sensoreinheit sowie ein Sensorsystem, insbesondere für ein Sicherheitssystem für ein Fahrzeug, bereitzustellen, das die Nachteile aus dem Stand der Technik überwindet. Insbesondere ist es Aufgabe der vorliegenden Erfindung eine kostengünstige und robuste Sensoreinheit zu erhalten, die auch widerstandsfähig gegenüber äußeren, mechanischen Umwelteinflüssen ist.

Diese Aufgabe wird erfindungsgemäß durch eine Sensoreinheit mit den Merkmalen des unabhängigen Anspruchs 1, insbesondere aus dem kennzeichnenden Teil, gelöst. Auch wird die Aufgabe durch ein Sicherheitssystem, insbesondere ein (Passiv oder Activ) Keyless-Entry-System für Fahrzeuge, mit den Merkmalen des unabhängigen Anspruchs 14 gelöst. Ebenfalls wird zur Lösung der Aufgabe ein Verfahren zur Herstellung einer Sensoreinheit mit den Merkmalen des Anspruchs 15, insbesondere aus dem kennzeichnenden Teil, vorgeschlagen. In den abhängigen Vorrichtungs- und Verfahrensansprüchen sind bevorzugte Weiterbildungen der Erfindung aufgeführt. Merkmale, die zur erfindungsgemäßen Sensoreinheit und/oder zum erfindungsgemäßen Sicherheitssystem offenbart werden, gelten dabei auch für das erfindungsgemäße Herstellungsverfahren und umgekehrt. Außerdem kann durch das erfindungsgemäße Verfahren aus Anspruch 15 die erfindungsgemäße Sensoreinheit hergestellt werden.

Die erfindungsgemäße Sensoreinheit zum berührungslosen Betätigen eines Stellelementes, insbesondere einer Klappe oder dergleichen eines Fahrzeugs weist zumindest ein kapazitives Sensorelement auf, wobei das Sensorelement wiederum einen Draht aufweist, der an einem Trägerelement angeordnet ist. Hierbei ist es erfindungsgemäß vorgesehen, dass das Trägerelement zumindest einen elektrisch leitenden Kern aufweist. Dieser elektrisch leitende Kern dient dazu, die messtechnischen Eigenschaften des kapazitiven Sensorelements zu verbessern und ggf. den Messbereich des Sensorelements zu erweitern. Zu diesem Zweck ist der elektrisch leitende Kern kapazitiv an den Draht vom Trägerelement angekoppelt. Somit bilden der Draht und der elektrisch leitende Kern gemeinsam das kapazitive Sensorelement, wodurch auch eine erforderliche Breite des Sensorelementes erreichbar ist. Hierfür ist es nicht notwendig, dass der Draht selbst direkt elektrisch leitend mit dem elektrisch leitenden Kern verbunden ist. Vielmehr kann auch eine (elektrische) Isolation zwischen dem Draht und dem elektrischen leitenden Kern vorgesehen sein. Durch die besonders einfache Ausgestaltung ist die erfindungsgemäße Sensoreinheit kostengünstig herstellbar, da eine automatisierte Fertigung der erfindungsgemäßen Sensoreinheit mit den kapazitiven Sensorelementen möglich ist. Außerdem sind die vorhandenen kapazitiven Sensorelemente besonders gut gegen äußere mechanische Einflüsse geschützt, so dass ein dauerhafter Betrieb der Sensoreinheit insbesondere in einer rauen Messumgebung, wie z. B. im feuchten Außenbereich eines Fahrzeugs, sichergestellt ist. Durch die kapazitive Ankopplung des Drahtes an den elektrisch leitenden Kern verfügt das jeweilige kapazitive Sensorelement auch über hervorragende Messeigenschaften, die sich in Versuchen als sehr vorteilhaft herausgestellt haben. Außerdem ist es möglich, dass der Draht besonders vor äußeren Einflüssen geschützt am Trägerelement angeordnet werden kann. Somit dient das Trägerelement quasi als Gehäuse für den Draht. Auch ist es denkbar, dass der Draht mit dem Trägerelement in einem weiteren Gehäuse oder einer Hülle angeordnet sein kann, so dass diese Einheit sicher geschützt vor äußeren Einwirkungen, wie z. B. Feuchtigkeit, Salz oder dergleichen, ist.

Die erfindungsgemäße Sensoreinheit kann zumindest zwei oder mehrere kapazitive Sensorelemente aufweisen, die idealerweise über einen gemeinsamen Stecker miteinander verbunden sind. Auch ist es denkbar, dass für jedes Sensorelement ein getrennter Stecker zum Einsatz kommt. Üblicherweise werden die einzelnen nebeneinander oder höhenversetzt am Fahrzeug angeordnet, um somit einen Bewegungsablauf von einem Benutzer, z. B. durch einen angedeuteten Tritt oder ein Vorbeigehen erkennen zu können. Die erfindungsgemäße Sensoreinheit wird zu diesem Zweck mit einem Steuergerät elektrisch über die vorhandenen Stecker verbunden. Idealerweise läuft der Draht von den einzelnen Sensorelementen direkt in den Stecker, so dass auf Verbindungsstellen oder Übergangsstücke verzichtet werden kann. Hierdurch lassen sich ebenfalls Fertigungskosten reduzieren. Auch fällt somit eine kritische Schwachstelle bei der Sensoreinheit weg, da die Sensorelemente kontaktlos ausgestaltet sind, d. h. die Sensorelemente weisen keine elektrischen Kontaktstellen, auch keine umhüllten oder vergossenen Kontaktstellen, auf. In dem bereits erwähnten Steuergerät können auch mehrere Sensoreinheiten zusammenlaufen und dort messtechnisch ausgewertet werden. Dieses Steuergerät kann dann die ermittelten Messsignale an die Fahrzeugelektronik oder einzelne Sicherheitssysteme weiterleiten. Vorzugsweise weist hierzu das Steuergerät eine Datenbusschnittstelle auf, z. B. in Form des CAN- oder LIN-Busses. Hierdurch lässt sich die erfindungsgemäße Sensoreinheit in die gesamte Fahrzeugelektronik auf einfache Art und Weise integrieren.

Erfindungsgemäß ist es denkbar, dass der Draht im Wesentlichen parallel zu einer Längsrichtung des Trägerelements verläuft. Hierdurch kann auf eine Aufwicklung des Drahtes, um eine bestimmte Breite des Messbereiches zu erreichen, am Trägerelement verzichtet werden. Somit verläuft der Draht im Wesentlichen linear am Trägerelement und ein besonders kurzer Draht kann damit verwendet werden, der auch besonders einfach und sicher an dem Trägerelement befestigt werden kann.

Ferner ist es erfindungsgemäß vorgesehen, dass der Draht endlos am Trägerelement angeordnet ist, wobei insbesondere beide Enden des Drahtes an einem Ende des Trägerelements, insbesondere hervorstehend, vorgesehen sind. Unter dem Begriff "endlos" wird dabei verstanden, dass der Draht nicht einfach am oder im Trägerelement endet, sondern dass nur eine Schlaufe oder ein Mittelstück des Drahtes vollständig am Trägerelement angeordnet ist und die beiden Enden des Drahtes idealerweise an dem erwähnten Stecker angeschlossen sind. Hierdurch ist es möglich, über eine einfache Widerstandsmessung die Funktionsfähigkeit des Sensorelements bzw. der erfindungsgemäßen Sensoreinheit zu überprüfen. Ferner ist auch eine Steckererkennung mit dem Steuergerät einfach möglich, da eine Widerstandsmessung hierzu direkt Aufschluss gibt. Auch eine permanente Bruchüberwachung des kapazitiven Sensorelements mit dem durchgängigen Draht, der endlos am Trägerelement befestigt ist, ist somit einfach möglich. Außerdem weist die endlose Anordnung auch den Vorteil auf, dass keine zusätzlichen elektrisch leitenden Kontaktstellen am Trägerelement vorgesehen sind, die immer eine Schwachstelle darstellen, da diese vor Korrosion und mechanischen Belastungen unbedingt geschützt werden müssen. Ein durchgehender Draht weist somit den wesentlichen Vorteil auf, dass er gerade über derartige Schwachstellen nicht verfügt.

Ebenfalls ist es im Rahmen der Erfindung möglich, dass der Draht im Wesentlichen in einer Ebene am Trägerelement angeordnet ist. Hierbei hat es sich als vorteilhaft herausgestellt, wenn die gedachte Ebene des Drahtes möglichst nah und/oder parallel zu dem elektrisch leitenden Kern angeordnet ist, wodurch insgesamt die kapazitive Leistung des Sensorelements verbessert wird. Hierfür ist es auch von Vorteil, wenn eine Isolation zwischen dem Draht und dem elektrisch leitenden Kern eine hohe Permittivitäts- oder Dielektrizitätszahl aufweist. Durch den Einsatz des elektrischen Kerns am bzw. im Trägerelement wird der Messbereich des kapazitiven Sensorelements deutlich verbessert bzw. vergrößert. Im Gegensatz zu dem Messbereich des bloßen Drahtes kann der Messbereich des kapazitiven Sensorelements mit dem elektrisch leitenden Träger um ein Vielfaches vergrößert werden.

Auch ist es bei der vorliegenden Erfindung denkbar, dass ein Stück des Drahtes, der direkt am Trägerelement angeordnet ist, eine Länge aufweist, die im Wesentlichen doppelt so lang ist, wie eine Länge des Trägerelements. Somit wird deutlich, dass der Draht an einem Ende des Trägerelements hin und auch zurück geführt wird. Dabei ist es vorteilhaft, wenn der Draht über die gesamte Länge des Trägerelements entlang geführt wird und am gegenüberliegenden Ende eine Wende um ca. 180° stattfindet, um vom anderen Ende, dem zweiten Ende, wieder zum ersten Ende zurückzuführen. Hierbei ist der Draht insbesondere U-förmig am Trägerelement angeordnet, wobei die Umlenkung des Drahtes am zweiten Ende auch außerhalb, d. h. nicht direkt am Trägerelement stattfinden kann.

Um die Messeigenschaften der erfindungsgemäßen Sensoreinheit zu verbessern, kann der elektrisch leitende Kern großflächig ausgestaltet sein. Dieser elektrisch leitende Kern kann vollständig im Trägerelement angeordnet sein oder auch nur am Trägerelement. Wichtig ist jedoch die kapazitive Einkoppelung des Drahtes an den elektrisch leitenden Kern.

So ist an dieser Stelle erwähnt, dass es auch denkbar ist, dass der elektrisch leitende Kern das Trägerelement vollständig bildet. Darunter ist zu verstehen, dass der elektrisch leitende Kern selbst das Trägerelement darstellt. Hierbei ist es zweckmäßig, wenn der eingesetzte Draht selber eine Isolation aufweist, die den Draht galvanisch vom Trägerelement trennt.

Ebenfalls ist es denkbar, dass das Trägerelement mit einer Schutzhülle umhüllt oder umspritzt wird, die insbesondere eine elektrische Isolation darstellt. Auch in diesem Fall kann das Trägerelement vollständig aus dem elektrisch leitenden Kern bestehen. Selbstverständlich kann auch ein Trägerelement, welches selbst aus nicht leitendem Material besteht, und einen elektrisch leitenden Kern aufweist, beschichtet oder umhüllt sein.

Des Weiteren ist es im Rahmen der Erfindung möglich, dass der elektrisch leitende Kern flach ausgestaltet ist. Es ist erfindungsgemäß vorgesehen, dass der elektrisch leitende Kern folienartig ausgestaltet ist. Zweckmäßigerweise hat es sich herausgestellt, dass der Kern eine Dicke von kleiner 5 mm, bevorzugt kleiner 2 mm und besonders bevorzugt kleiner 0,5 mm aufweist. Dabei weist die abnehmende Dicke des elektrisch leitenden Kerns auch den Vorteil auf, dass das gesamte Sensorelement flexibler wird, da eine mechanische Verformung des elektrisch leitenden Kerns mit abnehmender Dicke erleichtert wird.

Des Weiteren ist es im Rahmen der Erfindung möglich, dass der elektrisch leitende Kern sich im Wesentlichen über die gesamte Länge und/oder Breite des Trägerelements erstreckt. Somit muss der Kern nicht unbedingt vollständig in dem Trägerelement angeordnet sein, sondern kann am ersten oder zweiten Ende des Trägerelements auch mit dem Trägerelement abschließen. Dadurch, dass jedoch der Kern sich über die gesamte Länge und/oder gesamte Breite des Trägerelements erstreckt, kann auch ein besonders langer und/oder breiter Messbereich der erfindungsgemäßen Sensoreinheit erreicht werden. Außerdem ist die Herstellung des Trägerelements somit auch einfacher, da quasi das Trägerelement als Endlosmaterial bzw. Meterware, insbesondere im (Kunststoff-) Stranggussverfahren, hergestellt werden kann, indem ein sehr langer, elektrisch leitender Kern eingebettet ist. Für die Herstellung der erfindungsgemäßen Sensoreinheit muss dann nur der Strang des Trägerelements auf seine gewünschte Länge abgeschnitten werden, wobei dann nur noch der elektrisch leitende Draht befestigt wird, was vorteilhafterweise durch ein Anclipsen erfolgt.

Um die Kürzung des Trägerelements (gerade bei Meterware) auf seine gewünschte Länge besonders einfach auszugestalten, kann es vorgesehen sein, dass der elektrisch leitende Kern und/oder das Trägerelement über entsprechende Trennstellen und/oder Sollbruchstellen bzw. Trennfugen verfügt. Somit kann das insbesondere als Meterware hergestellte Trägerelement mit dem elektrisch leitenden Kern durch einfaches Trennen (z. B. Schneiden, Sägen oder Abdrehen bzw. Reißen) auf die gewünschte Länge gebracht werden. Zu diesem Zweck kann der elektrisch leitende Kern die bereits erwähnten Trennstellen und/oder Sollbruchstellen aufweisen. Bei dem Trägerelement können hierzu die bereits erwähnten Trennfugen vorhanden sein. Zweckmäßigerweise liegen die Trenn- und/oder Sollbruchstellen vom Kern geometrisch überein mit den Trennfugen vom Trägerelement.

Da der elektrisch leitende Draht endlos am Träger geführt wird, kann dieser zuvor mit dem Stecker versehen werden, so dass die gesamte Herstellung der erfindungsgemäßen Sensoreinheit besonders einfach, im Wesentlichen automatisiert und in wenigen Fertigungsschritten durchführbar ist. Außerdem können auch individuell veränderbare Sensoreinheiten hergestellt werden, da wie bereits erwähnt, nur das Trägerelement auf die entsprechende Länge gekürzt werden muss und dann der entsprechend lange Draht daran angeordnet wird. Weitere individuelle Herstellungskriterien sind somit nicht erforderlich. Damit ist eine gewünschte Massenfertigung möglich.

Des Weiteren ist es erfindungsgemäß möglich, dass am Trägerelement ein Buckel angeordnet ist, der insbesondere im Bereich einer Trennfuge vom Trägerelement und/oder einer Trennstelle oder Sollbruchstelle vom Kern angeordnet ist. Der zuvor erwähnte Buckel stellt eine Materialanhäufung/-ansammlung vom Trägerelement dar, mit dem ein gekürztes Trägerelement an einer Trennstelle verschlossen werden kann. Hierzu kann der Buckel verwendet werden, der durch Erwärmung die Trennstelle vom Trägerelement stoffschlüssig verschließt, um somit den elektrisch leitenden Kern optimal gegen Korrosion zu schützen. Auch bei einem elektrisch leitenden Kern, der aus korrosionsgeschütztem Material besteht, kann es sinnvoll sein, die Trennstelle vom Trägerelement mit dem Material vom Buckel stoffschlüssig zu verschließen, damit sich in diesem Bereich in einer möglichen Ausnehmung, keine Feuchtigkeit oder Wasser ansammeln kann. Gerade Feuchtigkeit und Wasser verfälschen das Messergebnis eines kapazitiven Sensors deutlich. Somit dient der erwähnte Buckel dazu, die Trennstelle und insbesondere eine vorhandene Ausnehmung beim abgetrennten Trägerelement stoffschlüssig zu verschließen. Idealerweise sind die Buckel im Bereich der Trennfugen vom Trägerelement oder im Bereich der Trennstellen bzw. Sollbruchstellen vom Kern angeordnet.

Ferner ist es erfindungsgemäß denkbar, dass der elektrisch leitende Kern des Trägerelements oder das Trägerelement selbst im Wesentlichen von einer insbesondere ebenen Schutzhülle umgeben ist, die auch teilweise als Grundplatte bezeichnet wird. Diese Schutzhülle kann gleichzeitig die elektrische Isolation aufweisen, weshalb sie zweckmäßigerweise aus Kunststoff bestehen kann. Sofern die Schutzhülle eine elektrische Isolation darstellt, ist somit sichergestellt, dass der Draht galvanisch getrennt vom Kern des Trägerelements angeordnet ist.

Unabhängig von der Ausgestaltung des Trägerelements kann es ebenfalls vorgesehen sein, dass der Draht zumindest im Bereich des Trägerelements mit einer elektrischen Isolation versehen ist. Zweckmäßigerweise können für den Draht Standarddrähte verwendet werden, die kostengünstig und als Massenware erhältlich sind. Hierbei kann ein Draht nach dem Standard: FLRY oder FLY verwendet werden. Bei diesem Draht kann es sich um eine einadrige Leitung handeln, die insbesondere mehrere Kupferlitzen aufweisen kann. Ein idealer Querschnitt des Drahtes beträgt ca. 1 mm, jedoch sind auch dünnere oder dickere Querschnitte denkbar. Bei den dünneren Drähten besteht jedoch das Risiko, dass ihre mechanische Belastbarkeit relativ gering ist und somit beim Befestigen des Drahtes am Trägerelement Schäden entstehen können. Die dickeren Drähte ziehen einen Kostennachteil nach sich, da deutlich mehr Kupferanteil verbraucht wird. Somit steigen im Wesentlichen nur die Kosten durch den erhöhten Kupferverbrauch, nicht jedoch die technischen Leistungen des Sensorelements. Idealerweise ist der Draht mit einer durchgehenden Isolationsschicht versehen, die bis zum Stecker der Sensoreinheit durchgeführt ist.

Die verwendeten Sensorelemente je Sensoreinheit können vorzugsweise baugleich bzw. identisch ausgestaltet sein. Hierdurch lassen sich die Fertigungskosten weiter reduzieren, da die Stückzahlen je Sensorelement deutlich steigen. Allerdings ist es auch denkbar, dass zwei oder mehrere nicht baugleiche Sensorelemente eine Sensoreinheit bilden. So kann z. B. die Länge des Sensorelementes, die im Wesentlichen auch durch die Länge des Trägerelementes vorgegeben ist, variieren. Auch die Breite des jeweiligen Sensorelementes von einer Sensoreinheit kann unterschiedlich ausgestaltet sein. Hierdurch lassen sich zwar nicht die Fertigungskosten reduzieren, jedoch ist eine verbesserte Einsatzfähigkeit der entsprechenden Sensoreinheit am Fahrzeug erreichbar.

Außerdem ist es im Rahmen der Erfindung denkbar, dass zumindest ein kapazitives Sensorelement der Sensoreinheit über eine bereichsweise Abschirmung verfügt. Hierdurch kann der Messbereich des Sensorelementes gezielt beeinflusst werden, um z. B. Störungen, die sonst vom Sensor miterfasst werden und eigentlich außerhalb des gewünschten Messbereiches liegen, auszublenden. So kann der Bereich des Drahts zwischen dem Stecker und dem Trägerelement mit einer Abschirmung versehen sein. Bei der Abschirmung kann es sich ebenfalls nur um einen Draht handeln oder um eine Metallfolie oder ein flaches Band, welches über ein anderes elektrisches Potential verfügt als der elektrische (Mess-) Draht des kapazitiven Sensorelementes, vorzugsweise ist die Abschirmung "geerdet" bzw. mit dem Nullpotential versehen. Selbstverständlich können auch zwei getrennte Abschirmungsdrähte an einem kapazitiven Sensorelement vorgesehen sein, auch ist es denkbar, dass ein zusätzliches Abschirmelement bei der erfindungsgemäßen Sensoreinheit zum Einsatz kommt, welches z. B. neben den beiden kapazitiven Sensorelementen oder hinter den beiden kapazitiven Sensorelementen angeordnet ist.

Um die Flexibilität der Sensorelemente zu verbessern, kann es erfindungsgemäß vorgesehen sein, dass der elektrisch leitende Kern kammartig, insbesondere doppelkammartig ausgestaltet ist. Unter kammartig wird verstanden, dass von einem Mittelsteg einzelne Zinken, insbesondere senkrecht, abgehen, wobei die Zinken parallel zueinander an dem Mittelsteg angeordnet sind. Unter doppelkammartig wird verstanden, dass beidseitig von dem Mittelsteg die Zinken angeordnet sind. Um die Flexibilität des kammartigen Kerns zu verbessern, ist es vorgesehen, dass alle Zinken auf der gleichen Höhe des Mittelstegs angeordnet sind, so dass kein Versatz der beidseitig zueinander angeordneten Zinken vorhanden ist. Außerdem kann durch diese kammartige Ausgestaltung auch weiter Materialkosten eingespart werden, da eben zwischen einzelnen Zinken des kammartigen Kerns Zwischenräume entstehen, die materialfrei sind.

Damit die erfindungsgemäßen Sensorelemente möglichst korrosionsfrei ausgestaltet sind, ist es vorgesehen, dass der elektrisch leitende Kern Edelstahl, Kupfer, Messing und/oder leitfähige Polymere aufweist. Die zuvor genannten Materialien weisen den Vorteil auf, dass sie einerseits elektrisch leitend sind und andererseits korrosionsunempfindlich sind. Sofern das Trägerelement als Meterware hergestellt wird, ragen somit die Enden des elektrisch leitenden Kerns ungeschützt aus dem Trägerelement. Unter dem Begriff Meterware soll im Rahmen der Erfindung langes stangenförmiges Material verstanden werden (mehrere Meter lang), aus dem dann die gewünschten Längen für das Trägerelement durch Abschneiden hergestellt werden. Edelstahl weist dazu den Vorteil auf, dass es deutlich kostengünstiger als Messing oder Kupfer ist. Kupfer und Messing weisen dahingehend sehr gute elektrische Leifähigkeit auf, wodurch die Messfähigkeit des Sensorelements verbessert wird. Ebenfalls ist es denkbar, dass der elektrisch leitende Kern auch ein leitfähiges Polymer aufweist, so dass das gesamte Trägerelement hoch flexibel ausgestaltet werden kann. Alle zuvor genannten Materialien können flach und kammartig bzw. doppelkammartig als elektrisch leitender Kern ausgestaltet sein.

Sofern der leitfähige Kern oder das gesamte Trägerelement leitfähiges Polymer aufweist, kann es sich hierbei um eines der folgenden Materialien handeln:
- PEDOT:PSS
- Polyacetylen
- Polyanilin
- Polyparaphenylen
- Polypyrrol
- Polythiophen

Derartige elektrisch leitende Polymere zeichnen sich durch intrinsische elektrische Leitfähigkeit aus. So besitzen derartige Polymere ein ausgedehntes π-Elektronensystem. Erst bei einer Dotierung der Polymere kommt es zu einer deutlichen Erhöhung der elektrischen Leitfähigkeit. Mit starken Oxidations- oder Reduktionsmitteln entstehen delokalisierte ionische Zentren im Polymer, zu denen das jeweilige Dotierungsmittel Gegenionen bildet. Auch ist es bei manchen Polymeren, insbesondere bei Elastomeren, thermoplastische Elastomeren oder Thermoplasten möglich, eine Leitfähigkeit durch Zumischung von Metallpulvern, Rußen oder Graphit zu erreichen. Gerade bei gummiartigen, elektrisch leitenden Polymeren lässt sich der Einsatz der erfindungsgemäßen Sensoreinheit dadurch verbessern, dass eine extreme Flexibilität des Sensorelements erreicht wird. Hierdurch kann auch die Außenkontur des Trägerelements verändert werden, so dass das Trägerelement z. B. einen kreisförmigen oder rechteckförmigen Querschnitt aufweist und der Draht darin angeordnet ist.

Ferner ist es im Rahmen der Erfindung denkbar, dass am Trägerelement Befestigungsmittel, insbesondere in Form von Klemmen, angeordnet sind, durch die der Draht am Träger fixierbar und/oder befestigbar ist. Vorteilhafterweise kann eine derartige Befestigung durch einen Formschluss stattfinden, in den z. B. der Draht durch die vorgesehenen Befestigungsmittel anclipsbar oder verhakbar ist. Bei dieser Variante ist es zusätzlich von Vorteil, wenn die bereits erwähnte Schutzhülle bzw. Grundplatte des Trägerelements einteilig und/oder materialeinheitlich mit den Befestigungsmitteln ausgestaltet ist. Zweckmäßigerweise wird hierzu der elektrisch leitende Kern durch ein Kunststoffspritzgussteil umhüllt, an dem direkt die Befestigungsmittel angeformt sind. Wie bereits erwähnt, kann ein derartiges Trägerelement als Strang-Spritzguss-Material in Form von Meterware hergestellt werden. Über die vorhandenen Befestigungsmittel kann dann das gekürzte Trägerelement mit dem erforderlichen Draht versehen werden, so dass das Trägerelement mit dem elektrisch leitenden Kern und dem Draht die wesentlichen Bauelemente des kapazitiven Sensorelements bilden. Durch das Befestigungsmittel wird der Draht ganz oder teilweise am Trägerelement umhüllt angeordnet.

Die zuvor erwähnten Befestigungsmittel können einzeln oder abschnittsweise an dem Trägerelement angeordnet sein. Auch ist es denkbar, dass die Befestigungsmittel durchgehend über die Länge des Trägerelements an diesen angeordnet sind. Somit kann der Draht von einem Ende bis zum anderen Ende des Trägerelements durchgehend über die Befestigungsmittel am Trägerelement geschützt angeordnet sein. Nur am Ende des Trägerelements wird der Draht umgelenkt und über ein zweites Befestigungsmittel, welches wiederum von Anfang bis Ende durchgehend am Trägerelement angeordnet ist, geschützt zurückgeführt. Somit sind die beiden durchgehenden Befestigungsmittel insbesondere parallel zueinander am Trägerelement angeordnet. Um die messtechnischen Eigenschaften der Sensoreinheit zu verbessern, sind die beiden parallelen Befestigungsmittel vorzugsweise möglichst weit außen (über die Breite des Trägerelements gesehen) am Trägerelement angeordnet, wodurch sich der Messbereich verbreitern lässt. Das Befestigungsmittel selber ist im Wesentlichen hakenförmig ausgestaltet, wobei ein Steg bzw. Hals aus einer ebenen Fläche der Schutzhülle bzw. Grundplatte des Trägerelements herausragt, an den sich dann der Haken des Befestigungsmittels bzw. ein pilzkopfartiger Kopf anschließt. Dieser Haken bzw. pilzkopfartige Kopf ist derart umgeformt, dass er den Draht insbesondere formschlüssig am Trägerelement hält. Aufgrund der Flexibilität des Befestigungsmittels lässt sich somit der Draht durch das Befestigungsmittel an dem Trägerelement festclipsen. Hierbei kann ein Spalt zwischen dem Ende des Hakens bzw. pilzkopfartigen Kopfes des Befestigungsmittels zum Trägerelement schmaler als die maximale Dicke des Drahtes ausgestaltet sein. In einem bevorzugten Fall ist der Spalt quasi nicht vorhanden, so dass das Befestigungsmittel mit seinem offenen Haken wieder die bereits erwähnte Grundplatte bzw. ebene Schutzhülle des Trägerelements berührt, jedoch nicht mit dieser verbunden ist. Der vorhandene Spalt zwischen dem offenen Ende des Befestigungsmittels und der Grundplatte des Trägerelements kann nach außen oder innen, gesehen über die Breite des Trägerelements, angeordnet sein. Sofern das hakenförmige Befestigungsmittel nach außen geöffnet ist, ist die Montage des Drahtes besonders einfach. Ist jedoch die Öffnung des hakenförmigen Befestigungselements nach innen, d. h. zur Mittelachse des Trägerelements gerichtet, so ist der Draht ideal geschützt am Trägerelement angeordnet. Optional ist es denkbar, dass an dem Befestigungsmittel noch zusätzlich Sperrlaschen angeordnet sind, durch die sichergestellt wird, dass der Draht nach der Montage am Trägerelement nicht mehr aus dem Befestigungsmittel gelangen kann. Ebenfalls ist es denkbar, dass die Öffnung des hakenförmigen Befestigungsmittels stoffschlüssig nach der Montage des Drahtes verschlossen wird. Dieses kann z. B. durch eine Vergussmasse oder Silikon oder Verschweißen erfolgen. Somit wird sichergestellt, dass der Draht völlig geschützt vom Befestigungsmittel umhüllt am Trägerelement angeordnet ist.

Um insbesondere den umgelenkten Draht am Ende des Trägerelements ebenfalls geschützt anzuordnen, kann eine Kappe vorgesehen sein, die über ein Ende des Trägerelements gesteckt wird und ggf. den Draht darunter sicher anordnet. Diese Kappe kann z. B. an das entsprechende Ende des Trägerelements angeclipst, angeklebt oder aufgeschweißt werden. Gerade wenn das Trägerelement als Meter- oder Massenware hergestellt wird, ist es von Vorteil, wenn zumindest das abgetrennte Ende vom Trägerelement mit der Kappe umschlossen ist. Dabei kann die Kappe auch zur Führung des Drahtes dienen, insbesondere wenn die Kappe nicht das Ende des Trägerelements schließt, bei dem der Draht umgelenkt wird. So kann an der Kappe eine Zugentlastung für den Draht vorgesehen sein, um den Draht mit seinen beiden Enden mechanisch an der Kappe bzw. dem Trägerelement zu fixieren. Somit kann insgesamt eine besonders preiswerte Herstellung des erfindungsgemäßen Sensorelements stattfinden. Außerdem kann die Kappe auch ein abgetrenntes Ende vom Trägerelement, insbesondere den elektrisch leitenden Kern vom Trägerelement, vor Umwelteinflüssen und Korrosionserscheinungen schützen. Gleichzeitig kann die Kappe auch zur Befestigung des Sensorelements am Fahrzeug dienen, indem die Kappe über entsprechende Befestigungsmittel verfügt. Sofern jedoch das gesamte Trägerelement mit dem angeordneten Draht noch einmal z. B. durch einen Schlauch umhüllt wird oder in einem Gehäuse angeordnet wird, kann auf diese zusätzliche Kappe verzichtet werden.

Wie zuvor bereits erwähnt worden ist, dienen die Befestigungsmittel am Trägerelement zur Führung und Stützung des Drahtes am Trägerelement. Hierzu kann das Befestigungselement über einen Hals und ein pilzkopfartiges Ende verfügen, um somit hakenförmig ausgestaltet zu sein. Es ist ferner von Vorteil, wenn der Draht innerhalb der Führung durch das Befestigungsmittel am Trägerelement längsverschiebbar ist. Hierdurch kann die Flexibilität des gesamten Sensorelementes zusätzlich verbessert werden, wobei mechanische Zug- und/oder Druckspannungen im Draht vermieden werden.

Im Rahmen der Erfindung ist es besonders vorteilhaft, wenn das Sensorelement mit seinem Trägerelement und dem Draht insgesamt flexibel, insbesondere in Längsrichtung, ausgestaltet ist. Hierdurch lässt sich auf einfache Art und Weise das Trägerelement beispielsweise an die verschiedenen Innenkonturen eines Stoßfängers bei einem Fahrzeug anpassen. Damit wird das Trägerelement an die jeweilige Form des Stoßfängers oder des Türschwellers oder dergleichen bei der Montage angepasst. Auch kann damit das Sensorelement über Ecken und Kanten am Fahrzeug geführt werden, wodurch z. B. auch der Messbereich des Sensorelementes um 90° gebogen werden kann, falls z. B. eine Messung von dem hinteren Seitenbereich zum Heckbereich des Fahrzeuges stattfinden soll. Um die notwendige Flexibilität zu erreichen, kann das Trägerelement selber aus einem flexiblen Grundstoff aufgebaut sein. Somit kann auf eine spezielle vorgefertigte Form des Trägerelements verzichtet werden, wodurch zusätzliche Kosten eingespart werden können. Das Trägerelement kann zu diesem Zweck eine Grundplatte aufweisen, aus der insbesondere die Befestigungsmittel zur Fixierung des Drahtes herausragen.

Des Weiteren ist es erfindungsgemäß denkbar, dass am Trägerelement zumindest ein Deckelelement vorgesehen ist, wodurch das Trägerelement mit dem Draht bereichsweise abdeckbar ist. Auch kann das Deckelelement das Trägerelement vollständig abdecken, sodass der Draht unter dem Deckelelement sicher angeordnet ist und vor direkten mechanischen Einwirkungen geschützt ist. Vorzugsweise kann dieses Deckelelement stoffschlüssig oder über ein Scharnier oder dergleichen mit dem Trägerelement, insbesondere der Schutzhülle oder Grundplatte verbunden sein. Nach der Montage des Drahtes kann dann das Deckelelement geschlossen werden, so dass es als zusätzliches Schutzelement für den darunter liegenden Draht dient. Idealerweise ist das Deckelelement zumindest einseitig über ein Filmscharnier an dem Trägerelement, insbesondere der Grundplatte, gelenkig verbunden. Über eine Clipsverbindung ist dann das Deckelelement mit dem Trägerelement auch mit der weiteren Seite des Deckelelements verschließbar. Somit bildet das entsprechende Trägerelement selbst ein Gehäuse, in dem der aufgewickelte Draht sicher angeordnet ist.

Ferner ist es im Rahmen der Erfindung denkbar, dass das gesamte Trägerelement innerhalb eines Gehäuses oder einer Hülle, z. B. in Form eines Schlauches, angeordnet werden kann, um somit gegen äußere Einflüsse geschützt zu sein.

Auch ist es denkbar, dass das Trägerelement als Spritzgusselement aus einem stabilen Kunststoff ausgebildet ist. Hierbei kann über die Länge des Trägerelementes zumindest eine Trennfuge mit zumindest einem Verbindungssteg angeordnet sein, um eine Flexibilität des Trägerelementes insbesondere in Längsrichtung zu erreichen. Selbstverständlich können auch mehrere Trennfugen über die Länge eines Trägerelementes angeordnet sein, wodurch die Flexibilität weiter verbessert wird. Durch den Einsatz der Trennfugen ist es möglich, ein Spritzgusselement aus nur einem Material herzustellen, was einerseits stabil genug ist, um den aufgewickelten Draht zu führen und zu halten, und andererseits so flexibel ist, dass sich das Trägerelement bzw. das Sensorelement einer vorgegebenen Form, z. B. durch die Innenkontur bei einem Stoßfänger eines Fahrzeuges, anpassen lässt. Idealerweise ist im Bereich der Trennfuge nur ein Mittelsteg des elektrisch leitenden Kerns angeordnet.

Um die einzelnen Sensorelemente in der Sensoreinheit besonders einfach und sicher an dem Fahrzeug anzuordnen, kann es vorgesehen sein, dass am Trägerelement Haltemittel angeordnet sind, womit der Sensor am Fahrzeug befestigbar ist. Hierbei können die erwähnten Haltemittel eine stoff- und/oder kraft- und/oder formschlüssige Befestigung am Fahrzeug ermöglichen. Idealerweise sind die Haltemittel direkt an der Grundplatte oder dem Deckelelement vorgesehen bzw. daran angespritzt. Als Haltemittel können ebene Platten zum Einsatz kommen, womit z. B. das Sensorelement an dem Fahrzeug anklebbar oder verschweißbar ist. Auch können zapfenförmige oder pfeilförmige oder vorsprungartige Rastmittel als Haltemittel vorgesehen sein, womit sich das Trägerelement durch Anklipsen an dem Fahrzeug befestigen lässt. Je nach Ausgestaltung des Haltemittels kann eine irreversible oder reversible Befestigung des Sensorelementes am Fahrzeug stattfinden.

Auch ist es denkbar, dass das Trägerelement über externe Befestigungsmittel, wie z. B. Spangen oder Klemmen oder Schrauben und Nieten, am Fahrzeug befestigbar ist. So kann z. B. eine gehäuseförmige Spange zur Befestigung des Trägerelementes am Fahrzeug dienen, die gleichzeitig ein Gehäuse, abschnittsweise oder gesamt, für das Trägerelement bildet. Auch sind kombinierte Haltemittel im Rahmen der Erfindung denkbar.

Ferner ist die vorliegende Erfindung auch auf ein Sicherheitssystem zum insbesondere berührungslosen Öffnen und/oder Schließen einer Klappe eines Fahrzeuges oder dergleichen nach Anspruch 14 gerichtet. Hierbei kommt zumindest eine erfindungsgemäße Sensoreinheit (d. h. nach den Ansprüchen 1 bis 13) zum Einsatz. Wie bereits erwähnt worden ist, werden die einzelnen erfindungsgemäßen Sensoreinheiten über ein oder mehrere Steuergeräte mit dem Sicherheitssystem vom Fahrzeug verbunden. Dabei können die Steuergeräte auch in dem Sicherheitssystem integriert sein.

Ebenfalls ist die vorliegende Erfindung auch auf ein Verfahren zur Herstellung einer Sensoreinheit nach dem Oberbegriff von Anspruch 15 gerichtet. Hierbei ist es erfindungsgemäß vorgesehen, dass ein Draht endlos am Trägerelement fixiert wird. Bevor jedoch der Draht an dem Trägerelement fixiert werden kann, muss das Trägerelement selbst hergestellt werden. Dieses kann in einer bevorzugten Weise als Kunststoffspritzgussteil in Form von Meterware hergestellt werden. Dabei wird der elektrisch leitende Kern im Trägerelement direkt eingebettet bzw. das Trägerelement bildet selbst den Kern, sofern es elektrisch leitendes Polymer aufweist. Die zur Befestigung des Trägerelements vorzugsweise vorgesehenen Befestigungsmittel können dabei gleichzeitig mit hergestellt werden, genauso wie die weiteren zuvor erwähnten Elemente vom Trägerelement bzw., die die stoffschlüssig mit dem Trägerelement verbunden sein können, wie z. B. das Deckelelement. Nachdem nun das Trägerelement mit seinem Kern als Meterware hergestellt worden ist, muss dieses auf die gewünschte Länge gekürzt werden, was vorzugsweise durch (Laser-)Schneiden, Brechen, Drehen oder Sägen erfolgen kann. Nun weist das Trägerelement bereits die richtige Länge auf. An dieses Trägerelement wird dann der Draht fixiert, indem er mit Hilfe der Befestigungsmittel an das Trägerelement angeclipst wird oder in das Befestigungsmittel hineingedrückt oder eingezogen wird. Durch das Befestigungsmittel wird der Draht am Trägerelement zumindest teilweise oder vollständig umhüllt. Wie zuvor auch erwähnt, ist es denkbar, dass der Öffnungsspalt des hakenförmigen Befestigungsmittels noch stoffschlüssig, bspw. durch eine Schutzhülle oder einen Schrumpfschlauch, verschlossen wird. Sofern Buckel am Trägerelement vorhanden sind, kann damit vor oder nach der Montage des Drahtes eine Trennstelle eines Endes des Trägerelementes verschlossen werden. Zusätzlich kann wenigstens ein oder beide Enden vom Trägerelement mit einer Kappe versehen werden. Das fertig gestellte Trägerelement kann nun montiert werden, sofern der Draht bereits mit dem erforderlichen Stecker versehen ist.

Erfindungsgemäß können die Merkmale der Beschreibung und der Ansprüche und der erfindungsgemäßen Vorrichtung sowie des erfindungsgemäßen Verfahrens sowohl einzeln für sich als auch in den verschiedensten Kombinationen erfindungswesentlich sein. Weitere, die Erfindung verbessernde Maßnahmen werden nachstehend gemeinsam mit der Beschreibung der bevorzugten Ausführungsbeispiele der Erfindung anhand der Figuren näher dargestellt. Es zeigen:
- Figur 1: eine Draufsicht auf eine erfindungsgemäße Sensoreinheit mit zwei kapazitiven Sensorelementen,
- Figur 1a: ein Schnitt A-A durch die erfindungsgemäße Sensoreinheit aus Figur 1 im Bereich des Steckers,
- Figur 1b: ein Schnitt B-B durch ein erstes Sensorelement von der erfindungsgemäßen Sensoreinheit aus Figur 1,
- Figur 2: eine schematische Draufsicht auf einen Abschnitt eines Sensorelements von der erfindungsgemäßen Sensoreinheit,
- Figur 2a: ein Schnitt A-A durch das Sensorelement aus der erfindungsgemäßen Sensoreinheit von Figur 2,
- Figur 2b: ein Schnitt B-B aus Figur 2a im Bereich eines elektrisch leitenden Kerns von dem Sensorelement der erfindungsgemäßen Sensoreinheit aus Figur 2a und 2,
- Figur 3: ein vergleichbarer Schnitt A-A wie in Figur 2a durch ein optionales Sensorelement einer erfindungsgemäßen Sensoreinheit wie in Figur 2,
- Figur 4a: ein Schnitt A-A durch ein optionales Sensorelement, vergleichbar zu Figur 2a und 3 einer erfindungsgemäßen Sensoreinheit,
- Figur 4b: ein Schnitt B-B durch das Sensorelement der erfindungsgemäßen Sensoreinheit aus Figur 4a,
- Figur 5: eine teilweise Draufsicht auf eine erfindungsgemäße Sensoreinheit mit zwei Sensorelementen,
- Figur 5a: ein Schnitt A-A durch ein Sensorelement der erfindungsgemäßen Sensoreinheit aus Figur 5
- Figur 6: ein Schnitt A-A durch ein weiteres optional ausgestaltetes Sensorelement einer erfindungsgemäßen Sensoreinheit,
- Figur 7: eine Seitenansicht auf ein Fahrzeug mit einem erfindungsgemäßen Sicherheitssystem und zumindest einer erfindungsgemäßen Sensoreinheit,
- Figur 8a: ein vergleichbarer Schnitt B-B, vergleichbar zu Fig. 1b, durch ein weiteres Sensorelement, wobei der Kern eine Trennstelle aufweist,
- Figur 8b: ein vergleichbarer Schnitt B-B aus Figur 8a durch ein weiteres Sensorelement, wobei jedoch der Kern Sollbruchstellen aufweist,
- Figur 9: ein Schnitt A-A durch ein optional ausgestaltetes Sensorelement mit einem Buckel zum Verschließen einer Trennstelle des Trägerelements,
- Figur 10a: ein Schnitt A-A durch ein optional ausgestaltetes Sensorelement mit einem Buckel als Materialansammlung,
- Figur 10b: ein Schnitt B-B durch ein Sensorelement aus Figur 10a mit einer angedeuteten Kappe,
- Figur 11: eine schematische Draufsicht auf ein Anfangsende eines Trägerelements mit einer Kappe mit Zugentlastung,
- Figur 12a bis Figur 16b: Schnitte A-A durch optional ausgestaltete Sensorelemente mit unterschiedlichen Trägerelementen mit diversen Querschnitten.

In den Figuren werden für die gleichen technischen Merkmale auch für unterschiedliche Ausführungsbeispiele die identischen Bezugszeichen verwendet, wodurch auch eine Kombination der Merkmale für die Ausführungsbeispiele deutlich wird.

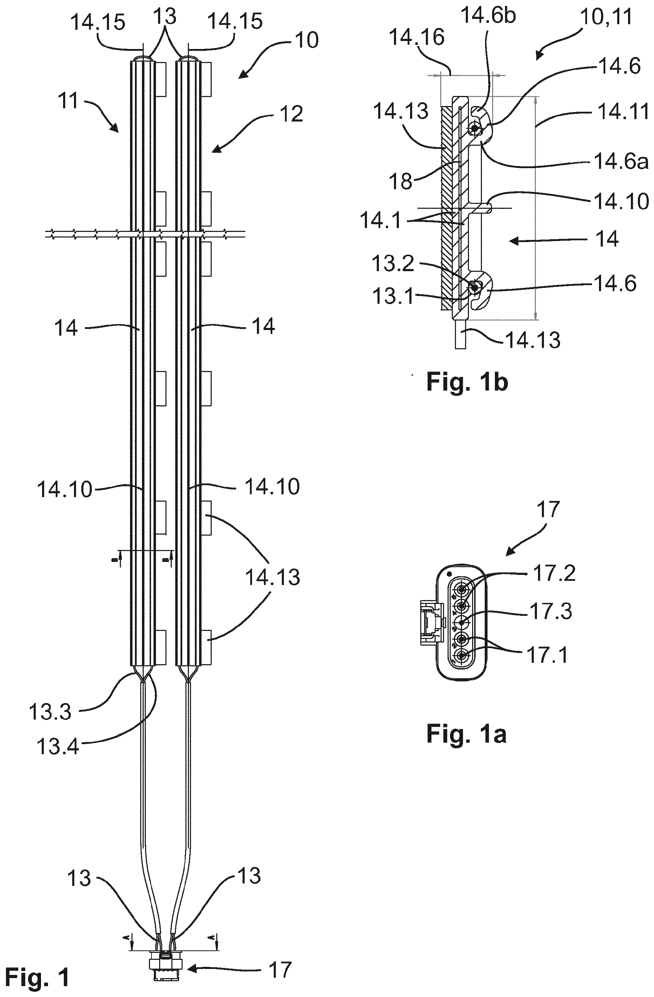

In Figur 1 ist eine erfindungsgemäße Sensoreinheit 10 in einem ersten Ausführungsbeispiel in Draufsicht dargestellt. Hierbei ist die erfindungsgemäße Sensoreinheit 10 komplett mit ihren beiden Sensorelementen 11, 12 erkennbar. Wie bereits erwähnt worden ist, ist es auch denkbar, dass die Sensoreinheit 10 auch über weitere baugleiche oder bauverschiedene Sensorelemente 11, 12 verfügt. In bzw. an jedem Sensorelement 11, 12 ist ein durchgehender Draht 13 angeordnet, der seinen Anfang und sein Ende im Stecker 17 hat. Somit verläuft der entsprechende Draht 13 endlos an einem Trägerelement 14 von dem Sensorelement 11 bzw. 12 und zwar im Wesentlichen parallel zur Längsrichtung 15. Das Ausführungsbeispiel aus den Figuren 1, 1a und 1b stellt u.a. eine bevorzugte Variante dar, da hierbei das verwendete Trägerelement 14 den vorhandenen Draht 13 durch die vorgesehenen Befestigungsmittel 14.6 mehr oder weniger vollständig schützt.

Wie weiter aus Figur 1 zu erkennen ist, sind seitlich an den Trägerelementen 14 der beiden Sensorelemente 11, 12 Haltemittel 14.13 angeordnet, die rechteckartig ausgestaltet sind und abschnittsweise über die Länge des jeweiligen Trägerelements 14 verteilt sind. Diese Haltemittel 14.13 können mit Klebestreifen versehen sein, um somit die erfindungsgemäße Sensoreinheit 10 an einem Fahrzeug 100 befestigen, insbesondere festkleben, zu können. Auch können die Haltemittel 14.13 dazu dienen, die Sensoreinheit 10 form- und/oder kraftschlüssig mit dem Fahrzeug 100, insbesondere einer Innenseite eines Stoßfängers oder eines Seitenschwellers zu befestigen.

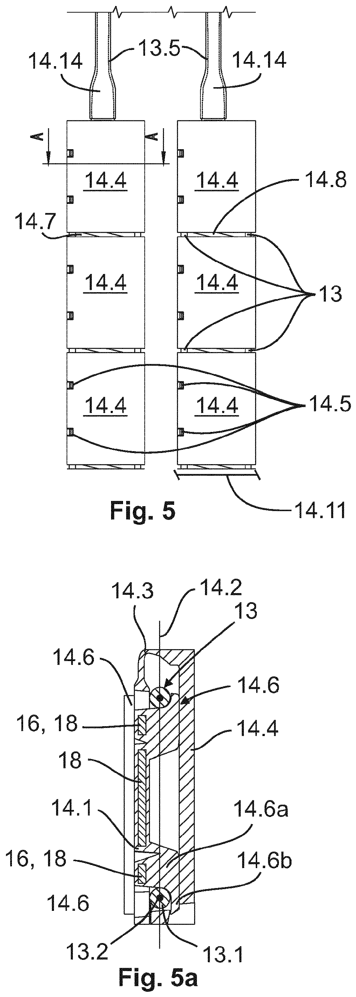

Wie ferner aus Figur 1 zu erkennen ist, verläuft der Draht 13 von jedem Sensorelement 11, 12 vom Stecker 17 bis zum jeweiligen Trägerelement 14 und wird dort parallel zur Längsachse 14.15 am Trägerelement 14 befestigt und verläuft von einem ersten Ende des Trägerelements 14 (Nähe von Stecker 17) bis zu einem zweiten Ende des Trägerelements 14 (s. Bezugszeichen 14.15 vom zweiten Ende des Trägerelements 14). Am zweiten Ende macht der Draht 13 insgesamt eine 180°-Wende und verläuft wiederum parallel zur Längsachse 14.15 vom zweiten Ende wieder zum ersten Ende des Trägerelements 14 zurück, um dann wieder im Stecker 17 zu enden. Im Bereich des Trägerelements 14 verläuft der Draht 13 im Wesentlichen parallel und wird hierzu, was in der Figur 1b näher zu erkennen ist, durch die Befestigungsmittel 14.6 am Trägerelement 14 gehalten. Diese endlose Anordnung des Drahtes 13 am Trägerelement 14 weist die bereits ausführlich genannten Vorteile auf. Zusätzlich kann zwischen dem Stecker 17 und dem Trägerelement 14 der Draht 13 mit einer Abschirmung 13.5 (s. Figur 5) versehen sein.

In Figur 1b ist ein Schnitt B-B durch das erste Sensorelement 11 der erfindungsgemäßen Sensoreinheit 10 aus Figur 1 dargestellt. Wie gut zu erkennen ist, ist der Draht 13 im äußeren Bereich des Trägerelements 14 durch jeweils ein Befestigungsmittel 14.6 am Trägerelement 14 gehalten. Das Trägerelement 14 weist eine Grundplatte 14.1 auf, die als Schutzhülle 14.1 für einen elektrisch leitenden Kern 18 dient. Die Grundplatte 14.1 bzw. die Schutzhülle 14.1 dient auch als elektrische Isolation für den elektrisch leitenden Kern 18, der in diesem Fall ausschließlich kapazitiv an den Draht 13 angekoppelt ist. Der Draht 13 wird über die beiden Befestigungsmittel 14.6 formschlüssig und ggf. kraftschlüssig an dem Trägerelement 14 fixiert. Wie gut aus der Figur 1b zu erkennen ist, sind die beiden Befestigungsmittel 14.6 randseitig am Trägerelement 14 angeordnet. Unter randseitig wird verstanden, dass diese quasi die gesamte Breite 14.11 des Trägerelements 14 ausnutzen und somit möglichst weit von der Längsachse 14.15 beabstandet sind. Die Befestigungsmittel 14.6 sind selbst hakenförmig ausgestaltet und verfügen über einen Steg 14.6a, an dem sich dann zum offenen Ende hin ein Haken 14.6b anschließt. Das offene Ende des Befestigungsmittels 14.6 weist nur einen geringen Spalt zur Grundplatte 14.1 auf. In dem vorliegenden Fall aus Figur 1b sind die beiden Befestigungsmittel 14.6 nach außen hin geöffnet. Auch ist es denkbar, dass der entsprechende Spalt vom Befestigungsmittel 14.6 nach innen, d. h. zur Längsachse 14.15 zeigt. Im mittleren Bereich des Trägerelementes (im Bereich der Längsachse 14.15) ist eine Rippe 14.10 angeordnet, die mehr oder weniger senkrecht aus der Grundplatte 14.1 herausragt und einheitlich und/oder materialeinheitlich mit der Grundplatte 14.1 ausgestaltet ist. Diese Rippe 14.10 kann zur besseren Handhabung des Trägerelements 14 dienen, um z. B. bei der Befestigung der Sensoreinheit 10 das Trägerelement 14 an die gewünschte Fläche vom Fahrzeug 100 halten und dann pressen zu können.

Wie aus der Figur 1b weiter zu erkennen ist, hat der elektrisch leitende Kern 18 ungefähr die gleiche Breite wie die Breite 14.11 vom Trägerelement 14. Nur an den beiden Randseiten wird jedoch der elektrisch leitende Kern 18 noch von dem Trägerelement 14 umhüllt. Auf der gegenüberliegenden Seite von der herausragenden Rippe 14.10 ist an der Grundplatte 14.1 das flache Haltemittel 14.13 angeordnet, welches z. B. aus doppelseitigem Klebeband bestehen kann. Außerdem ist gut zu erkennen, dass der Draht 13 eine Isolation 13.1 aufweist, die eine Seele 13.2 umgibt. Die Seele 13.2 stellt das eigentliche elektrisch leitende Element des Drahtes 13 dar. Bei der Seele 13.2 kann es sich um eine mehradrige Seele handeln oder um eine einadrige. Deutlich wird jedoch aus der Figur 1b, dass die Seele 13.2 keine elektrisch leitende Verbindung zum elektrisch leitenden Kern 18 aufweist. Somit wird klar, dass der Draht 13 nur kapazitiv an den elektrisch leitenden Kern 18 angekoppelt ist. Wie aus Fig. 1b auch gut zu erkennen ist, ist das gesamte Sensorelement 11, 12 flach ausgestaltet und verfügt somit über eine relative geringe Bauhöhe 14.16.

Aus der Figur 1a ist der Schnitt A-A aus Figur 1 im Bereich des Steckers 17 dargestellt. Dabei dienen die beiden unteren Kontakte 17.1 für die elektrische Kontaktierung des ersten Sensorelements 11. Zu diesem Zweck führt der Draht 13 vom ersten Sensorelement 11 mit seinem ersten Ende 13.3 vom Stecker 17 weg und endet mit seinem zweiten Ende 13.4 wieder beim Stecker 17. In der Mitte des Steckers 17 kann der Kontakt 17.3 z. B. für die Abschirmung 13.5 von dem Draht 13 für ein oder beide Sensorelemente 11, 12 dienen. Die beiden oberen Kontakte 17.2 des Steckers 17 sind für das zweite Sensorelement 12 vorgesehen. Der Stecker 17 selbst weist eine Labyrinth-Dichtung auf, so dass eine wasserdichte Verbindung zwischen dem Stecker 17 und einer entsprechenden Anschlussbuchse im Fahrzeug 100 möglich ist. Zusätzlich ist der Stecker 17 mit einer Rastsicherung ausgestattet, so dass der Stecker 17 mit der Anschlussbuchse formschlüssig verrastet und auch durch Vibrationen nicht freigerüttelt werden kann.

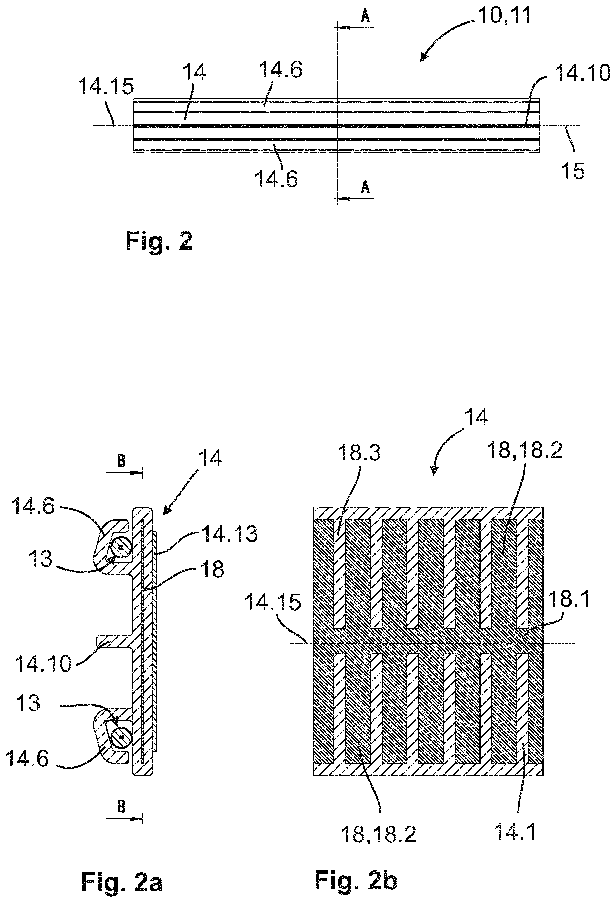

In der Figur 2 ist eine abschnittweise Draufsicht auf einen Teil der erfindungsgemäßen Sensoreinheit 10, bzw. genaugenommen des ersten Sensorelements 11, dargestellt. Dabei wird der Schnitt A-A angedeutet, der im Detail in der Figur 2a gezeigt ist. Wie in Figur 2 gut zu erkennen ist, verlaufen die beiden Befestigungsmittel 14.6 über die gesamte Länge 14.12 des Sensorelements 11 bzw. des entsprechenden Trägerelements 14.

In der Figur 2a ist ein vergleichbarer Schnitt wie in Figur 1b gezeigt. Hierbei ist wieder ein elektrisch leitender Kern 18 von einer Schutzhülle 14.1 des Trägerelements 14 umgeben, die auch als Grundplatte 14.1 ausgeformt ist. Daran angeformt sind die beiden Befestigungsmittel 14.6, die den Draht 13 formschlüssig am Trägerelement 14 halten. Auch in diesem Fall sind die beiden Befestigungsmittel14.6 hakenförmig ausgestaltet und ragen von der Grundplatte 14.1 ab, um den Draht 13 umhüllend aufzunehmen. In der Figur 2a ist noch der Schnitt B-B angedeutet, der in der Figur 2b näher dargestellt ist.

Wie in der ausschnittsweisen Figur 2b gut zu erkennen ist, ist der elektrisch leitende Kern 18 kammförmig ausgestaltet, wobei hier eine doppelkammförmige Form zum Einsatz kommt. Dabei weist der elektrisch leitende Kern 18 einen Mittelsteg 18.1 auf, der ungefähr im Bereich der Längsachse 14.15 angeordnet ist. Von diesem Mittelsteg 18.1 gehen einzelne Zinken 18.2 ab und zwar beidseitig, wobei zwischen den Zinken 18.2 jeweils Zwischenräume 18.3 vorgesehen sind. In dem vorliegenden Fall sind die beidseitigen Zinken 18.2 vom Mittelsteg 18.1 jeweils auf gleicher Höhe angeordnet, so dass kein Versatz zwischen den Zinken 18.2 entsteht. Hierdurch wird die Flexibilität des gesamten Trägerelements 14 in Richtung der Längsachse 14.15 verbessert. Damit lässt sich das Sensorelement 11, 12 besonders gut einer vorgegebenen Form am Fahrzeug 100 anpassen. In der Figur 2b ist dargestellt, dass die Zinken 18.2 breiter sind als die entsprechenden Zwischenräume 18.3 zwischen den Zinken 18.2. Allerdings kann auch das Breitenverhältnis umgekehrt sein, so dass die Zinken 18.2 deutlich schmaler ausgestaltet sind, als die entsprechenden Zwischenräume 18.3 zwischen den Zinken 18.2. Somit lässt sich weiterhin Material des elektrisch leitenden Kerns 18 einsparen und die Flexibilität des Trägerelements 14 verbessern.

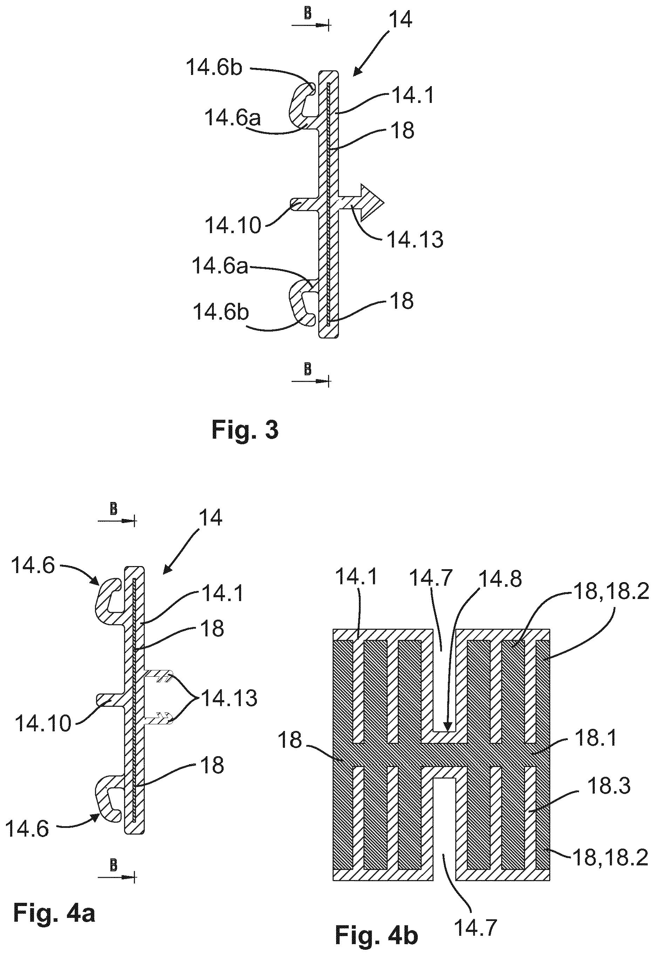

In der Figur 3 ist ein vergleichbarer Querschnitt A-A aus Figur 2 durch eine weitere erfindungsgemäße Sensoreinheit 10 dargestellt, wobei das Trägerelement 14 ohne den Draht 13 dargestellt ist. Im Wesentlichen unterscheidet sich das Trägerelement 14 durch das verwendete Haltemittel 14.13. Dieses ist einteilig und materialeinheitlich mit der Grundplatte 14.1 vom Trägerelement 14 hergestellt und weist eine pfeilkopfförmige Spitze auf, womit das Trägerelement 14 form- und/oder kraftschlüssig mit einem Gegenhaltemittel am Fahrzeug 100 befestigt werden kann. Hierzu braucht es nur in das Gegenhaltemittel hinein gedrückt zu werden, wozu wieder die Halterippe 14.10 dienen kann. Durch den entstehenden Anpressdruck verrastet bzw. verclipst das Trägerelement 14 automatisch mit den federnden Vorsprüngen vom Gegenhaltemittel, die formschlüssig mit der pfeilförmigen Spitze des Haltemittels 14.13 zusammenwirken. Aus der Figur 3 werden auch die beiden Befestigungsmittel 14.6 gut deutlich. Diese Befestigungsmittel 14.6 sind ebenfalls hakenförmig ausgestaltet, wobei zunächst ein Steg 14.6a, insbesondere senkrecht aus der Grundplatte 14.1 herausragt. An diesem Steg bzw. Hals 14.6a schließt ein Haken 14.6b bzw. pilzkopfartiger Kopf des Befestigungsmittels 14.6 an. Diese beiden Befestigungsmittel 14.6 gehen über die gesamte Länge 14.12 vom Trägerelement 14. Auch nutzen die beiden Befestigungsmittel 14.6 fast die vollständige Breite 14.11 des Trägerelements, um eine gute kapazitive Einkopplung des Drahtes 13 mit dem elektrisch leitenden Kern 18 vom Trägerelement 14 zu bewirken. Der elektrisch leitende Kern 18 kann als eine elektrisch leitende Folie bzw. dünnes Blech ausgestaltet sein. Die vorzugsweisen Materialien des elektrisch leitenden Kerns 18 wurden bereits zuvor eingehend diskutiert.

In Figur 3 kann das pfeilförmige Haltemittel 14.13 kontinuierlich, d. h. über die gesamte Länge 14.12 des Trägerelements 14 ausgestaltet sein oder aber auch nur abschnittsweise bzw. punktförmig. So können nach einem gewissen Abstand jeweils ein punktförmig ausgestaltetes Haltemittel 14.13 an der Grundplatte 14.1 des Trägerelements 14 angeordnet sein, um diese mit dem Fahrzeug 100 zu befestigen.

In der Figur 4a ist ein weiterer Querschnitt A-A, vergleichbar zu den Figuren 2a und 3, dargestellt. Im Wesentlichen unterscheidet sich dieses Trägerelement 14 in der Ausgestaltung des Haltemittels 14.13. Hierbei kommt quasi ein U-förmig ausgestaltetes Haltemittel 14.13 zum Einsatz, welches wieder auf der gegenüberliegenden Seite der Grundplatte 14.1 von der Längsrippe 14.10 angeordnet ist, um das Trägerelement 14 zu befestigen. Dabei sind an den U-förmig ausgestalteten Haltemittel 14.13 an den parallelen Schenkeln widerhakenförmige Rastmittel angeordnet, um somit das Trägerelement 14 form- und/oder kraftschlüssig mit dem Fahrzeug 100 bzw. einem entsprechenden Gegenhaltemittel zu verrasten. Zusätzlich können neben den dargestellten Haltemitteln 14.13 aus den Figuren 3 und 4a auch noch Klebestreifen auf der gleichen Seite der Haltemittel 14.13 angeordnet sein, um somit auch noch das Trägerelement 14 stoffschlüssig zu befestigen. Der Schnitt B-B durch die Figur 4a ist in der Figur 4b ausschnittsweise gezeigt. In Figur 4b ist gut zu erkennen, dass ein doppelkammförmiger elektrisch leitender Kern 18 in der ebenen Schutzhülle 14.1 vom Trägerelement 14 angeordnet ist. Hierbei weist jedoch die Kammstruktur des elektrisch leitenden Kerns 18 größere Zwischenräume 18.3 auf, die als Trennfugen 14.7 für das Trägerelement 14 dienen. Damit jedoch das Trägerelement 14 durchgehend ausgestaltet ist, dient u. a. der Mittelsteg 18.1 des elektrisch leitenden Kerns 18 als Verbindungssteg 14.8 im Bereich der Trennfuge 14.7. Wie in Figur 1b zu erkennen ist, wird jedoch der Mittelsteg 18.1 im Bereich des Verbindungsstegs 14.8 ebenfalls von der Schutzhülle bzw. Grundplatte 14.1 vom Trägerelement 14 umhüllt. Somit kann eine sehr hohe Flexibilität des Trägerelements 11, 12 erreicht werden, ohne dass jedoch die kapazitive Messfähigkeit des Sensorelements 11, 12 groß beeinflusst wird.

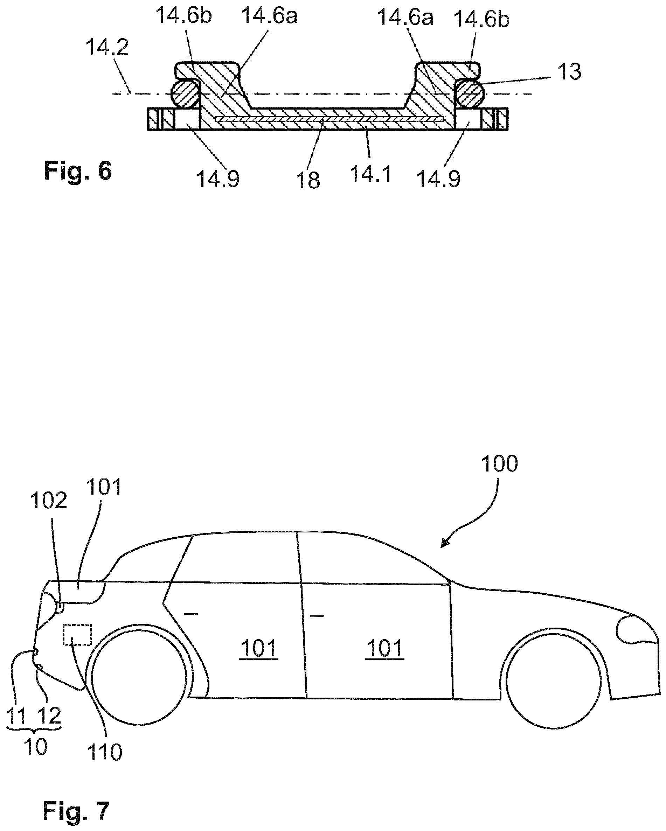

In der Figur 5 ist eine Detailvergrößerung einer optional ausgestalteten erfindungsgemäßen Sensoreinheit 10 aus Figur 1 dargestellt. Hierbei kommen grundsätzlich Deckelelemente 14.4 für die Trägerelemente 14 zum Einsatz. Dabei sind die ersten drei Deckelelemente 14.4 von jedem Trägerelement 14 der beiden Sensorelemente 11, 12 dargestellt. Wie in der Vergrößerung auch gut zu erkennen ist, sind die einzelnen Abschnitte des Trägerelements 14 mit den jeweiligen Deckelelementen 14.4 durch Trennfugen 14.7 getrennt, wobei die einzelnen Bereiche des Trägerelements 14 über Verbindungsstege 14.8 miteinander stoffschlüssig verbunden sind (s. auch Figur 4b). Diese Verbindungsstege 14.8 verlaufen im vorliegenden Bereich diagonal durch die Trennfugen 14.7 und verbinden die einzelnen Abschnitte des Sensorelements 11, 12. Ferner ist in der Figur 5 auch gut zu erkennen, dass an den ersten Enden des Trägerelements 14 jeweils ein Knickschutz 14.14 für die beiden Kabel 13 der Sensorelemente 11, 12 angeordnet sind. Innerhalb des Knickschutzes 14.14 kann auch jeweils eine Abschirmung 13.5, wie strichpunktiert angedeutet, verlaufen. Diese Abschirmung hat die Aufgabe elektromagnetische Störungen, die ein negatives Messergebnis herbeiführen können, zu vermeiden. In der Figur 5 sind die einzelnen Deckelelemente 14.4 auf dem Trägerelement 14 geschlossen, sodass der darunter liegende Draht 13 geschützt untergebracht ist. Die Befestigung des Drahtes 13 erfolgt wieder über die Befestigungsmittel 14.6, die auch nur punktförmig oder abschnittsweise in diesem Fall ausgestaltet sein können (s. bspw. Fig. 6).

In der Figur 5a ist ein Querschnitt A-A durch das erste Sensorelement 11 bzw. 12 gezeigt. Besonders hervorzuheben ist, dass der elektrisch leitende Kern 18 aus einzelnen Bereichen besteht, die in der Grundplatte 14.1 angeordnet ist. Diese einzelnen Abschnitte können elektrisch leitend miteinander verbunden sein und den gesamten Kern 18 bilden. Auch ist es denkbar, dass gerade aus Sicht der Figur 5a die oberen und unteren Abschnitte als Abschirmelemente 16 ausgestaltet sind, um somit das Messfeld des kapazitiven Sensors auszurichten. Damit bildet in diesem Fall nur der mittlere Abschnitt den elektrisch leitenden Kern 18 aus. Wie weiter aus der Figur 5a zu erkennen ist, ist das Deckelelement 14.4 über ein Scharnier 14.3 mit dem übrigen Trägerelement 14 verbunden. Dieses Scharnier ist im vorliegenden Ausführungsbeispiel als Filmscharnier ausgestaltet. Damit das Deckelelement 14.4 das Trägerelement 14 verschließt, sind zusätzlich Rastmittel 14.5 vorgesehen, sodass das Deckelelement 14.4 formschlüssig in der Schließposition am Trägerelement 14 durch die Rastmittel 14.5 gehalten ist.

Wie in Fig. 5a erkennbar ist, weist das Trägerelement 14 ebenfalls eine Grundplatte 14.1 auf, an dem einzelne Befestigungsmittel 14.6 angeordnet sind, um den Draht 13 zu halten. Diese Befestigungsmittel 14.6 sind stoffschlüssig mit der Grundplatte 14.1 verbunden und weisen einen Hals 14.6a auf, der in ein pilzkopfartiges bzw. kappenartiges Ende 14.6b übergeht. Mit diesem Ende 14.6b wird der Draht 13 an den Befestigungsmittel 14.6 niedergehalten, sodass er mehr oder weniger auf einer Ebene 14.2 angeordnet ist, die einen gleichbleibenden parallelen Abstand zum elektrisch leitenden Kern 18 aufweist.

Idealerweise wird die vorliegende Sensoreinheit 10 derart am Fahrzeug angeordnet, dass mechanische Einflüsse nicht von hinten auf die Grundplatte 14.1 des Trägerelementes 14 wirken, sondern von vorne auf das Deckelelement 14.4. Somit ist der funktionswesentliche Draht 13, durch den die Messfunktion der Sensoreinheit 10 sichergestellt wird, geschützt innerhalb des Trägerelementes 14 angeordnet.

In der Figur 6 ist der Querschnitt (vergleichbar zum Schnitt A-A aus Fig. 2) durch ein weiteres Trägerelement 14 dargestellt. Hierbei sind auch wieder die beiden randseitig angeordneten Befestigungsmittel 14.6 gut erkennbar, die zur Befestigung des Drahts 13 dienen. Auch diese beiden Befestigungsmittel 14.6 weisen einen Hals 14.6a auf, der mit der Grundplatte 14.1 stoffschlüssig verbunden ist. Das offene Ende der Befestigungsmittel 14.6 endet ebenfalls pilzkopfartig bzw. kappenartig im Ende 14.6b. In dieser Schnittdarstellung sind auch Ausnehmungen 14.9 erkennbar, die fertigungstechnisch von Vorteil sind

Ein wesentlicher Unterschied zwischen den Ausführungsbeispielen aus den Figuren 1 bis 4 und den vorliegenden Ausführungsbeispielen aus den Figuren 5 und 6 ist darin zu sehen, dass der Draht 13 nur an das Befestigungsmittel 14.6 vom Trägerelement 14 angelehnt ist und nicht verclipst oder eingeklemmt ist. Durch das zusätzliche Deckelelement 14.4 bzw. einen zusätzlichen Schlauch, in dem das Trägerelement 14 angeordnet werden kann, kann jedoch der Draht 13 nicht seine Position vom Trägerelement 14 verlassen.

In der Figur 7 ist ein Fahrzeug 100 mit dem erfindungsgemäßen Sicherheitssystem 110 sowie der erfindungsgemäßen Sensoreinheit 10 und den beispielhaften Sensorelementen 11 und 12 dargestellt. Um die Heckklappe 101 berührungslos öffnen zu können, ist ein Stellelement 102 in Form eines elektromechanischen Schlosses vorgesehen, was durch die Sensoreinheit 10 berührungslos ansteuerbar ist. Sofern das richtige Steuersignal von den beiden Sensorelementen 11 und 12 erkannt worden ist bzw. durch das entsprechende Steuergerät ermittelt worden ist, kann der Stellantrieb 102 angesteuert werden.

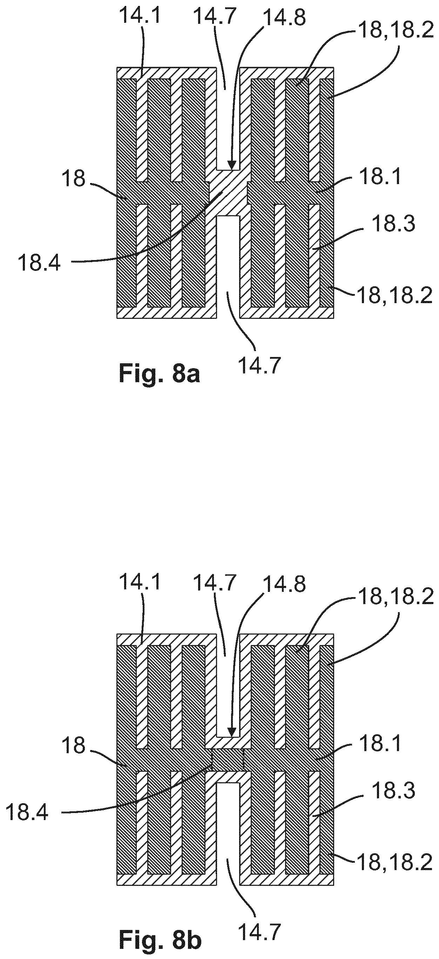

In der Figur 8a ist ein Schnitt B-B durch ein weiteres Sensorelement 11, 12 dargestellt. Dabei ist dieses Sensorelement 11 ähnlich zu dem Sensorelement 11 aus Figur 4b ausgestaltet. Allerdings ist der leitende Kern 18 längsseits unterbrochen und weist eine Trennstelle 18.4 im Trägerelement 14 auf. Wie in der Figur 8a zu erkennen ist, liegt diese Trennstelle 18.4 im Bereich der Trennfuge 14.7 vom Trägerelement 14. Gerade wenn das Trägerelement 14 mit dem integrierten Kern 18 als Meter- oder Massenware hergestellt wird, ist an der Trennstelle 18.4 bzw. der Trennfuge 14.7 eine einfache (Durch-)Trennung des Trägerelements 14 möglich. Bei der Ausgestaltung des Sensorelements 11 ist es ferner von Vorteil, dass die Trennstelle nicht weiter geschützt werden muss, da der Kern 18 im Bereich der Trennstelle 18.4 korrosionsgeschützt im Trägerelement 14 verbleibt.

In der weiteren Figur 8b ist ein weiterer Schnitt B-B durch ein vergleichbares Sensorelement 11, 12 aus Figur 4b sowie 8a dargestellt. Allerdings ist hier die Trennstelle 18.4 vom Kern 18 durch zwei Sollbruchstellen 18.4 ersetzt. Diese beiden Sollbruchstellen 18.4 können aus einer Perforation oder einer Einschnürung bzw. Einkerbung im Kern 18 bestehen. Durch die vorgegebenen Sollbruchstellen 18.4 vom Kern 18, die vorteilhafterweise im Bereich der Trennfuge 14.7 vom Trägerelement 14 liegen, ist eine einfache Durchtrennung des Trägerelements 14 an dieser Stelle möglich. Bei der abgebildeten Ausgestaltung des Sensorelements 11, 12 in Figur 8b ist es von Vorteil, dass der elektrisch leitende Kern 18 über seine Längserstreckung durchgehend galvanisch verbunden ist.

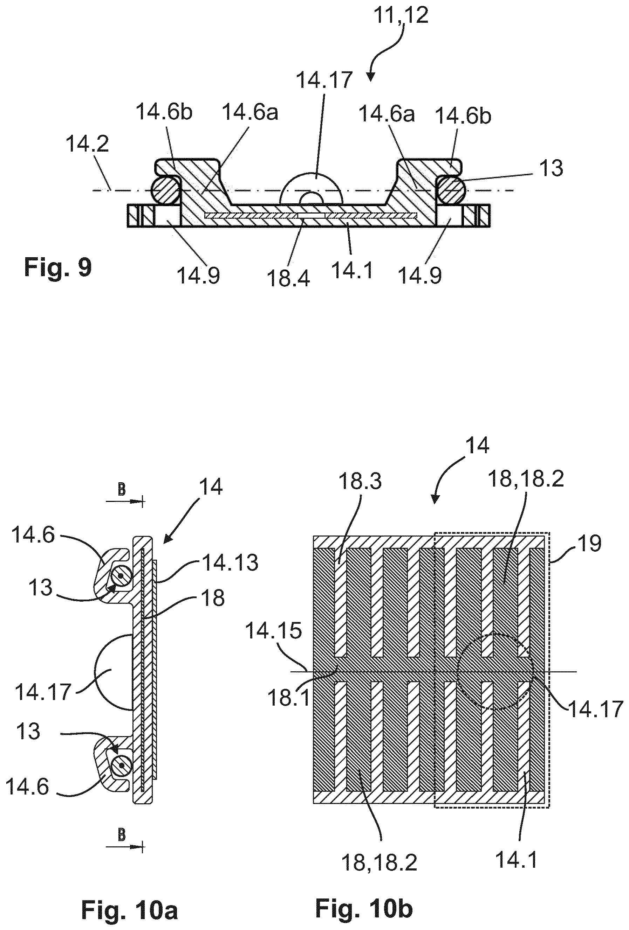

In der Figur 9 ist ein Schnitt A-A durch ein vergleichbares Sensorelement 11 aus Figur 6 dargestellt. Hierbei ist ein Buckel 14.17 an der Oberfläche des Trägerelements 14, insbesondere von der Grundplatte 14.1 angeordnet. Dieser Buckel 14.17 dient als eine Materialansammlung, um die Trennstelle des Trägerelements 14 nach einer Durchtrennung stoffschlüssig verschließen zu können. Hierbei kann das Verschließen durch Wärmeentwicklung erfolgen, indem der Buckel 14.17 aufgeschmolzen wird und das heiße Material auf die Trennstelle aufgebracht wird.

In der Figur 10a ist ebenfalls ein Schnitt A-A durch ein weiteres Sensorelement 11, vergleichbar zu dem Sensorelement 11 aus Figur 2, dargestellt. Auch hierbei kommt der bereits zuvor erwähnte Buckel 14.17 zum Einsatz. In der weiteren Figur 10b ist ein Schnitt B-B durch das Sensorelement 11 aus Figur 10a dargestellt. Dabei ist der Buckel 14.17 gestrichelt angedeutet, der oberhalb der Grundplatte 14.1 am Trägerelement 14 angeordnet ist. Ebenfalls ist eine Kappe 19 gestrichelt dargestellt, die bspw. ein abgetrenntes Ende des Trägerelements 14 umschließt und zusätzlich die Trennstelle vom Trägerelement 14 gegen äußere Einflüsse schützt.

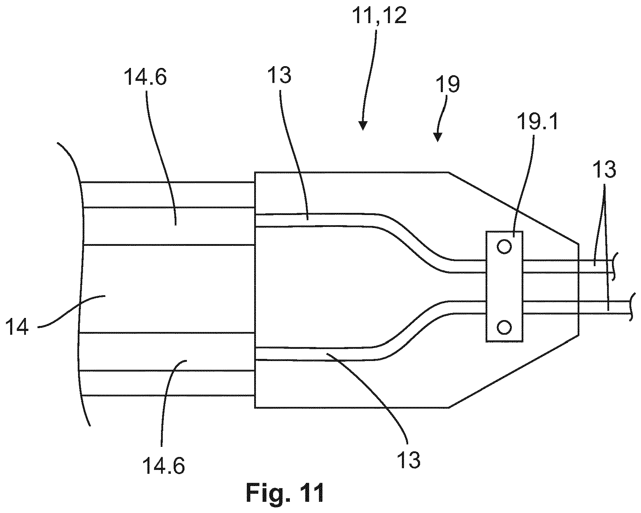

In der Figur 11 ist eine Draufsicht auf den Anfang eines Trägerelements 14 dargestellt, wobei das entsprechende Ende vom Trägerelement 14 mit einer Kappe 19 abgeschlossen ist. Diese Kappe 19 dient gleichzeitig zur Aufnahme und Befestigung des Drahtes 13 und weist eine Zugentlastung 19.1 auf. Damit schützt die Kappe 19 das Ende vom Trägerelement 14 nicht nur gegen äußere Umwelteinflüsse, sondern schützt gleichzeitig den Draht 13 gegen mechanische Belastungen an dieser Stelle. Die Kappe 19 kann an das Trägerelement 14 angeclipst, angeschweißt, aufgeklebt werden. Auch kann die Kappe 19 zur sicheren Aufnahme des umgelenkten Drahtes 13 am anderen Ende des Trägerelements 14 dienen.

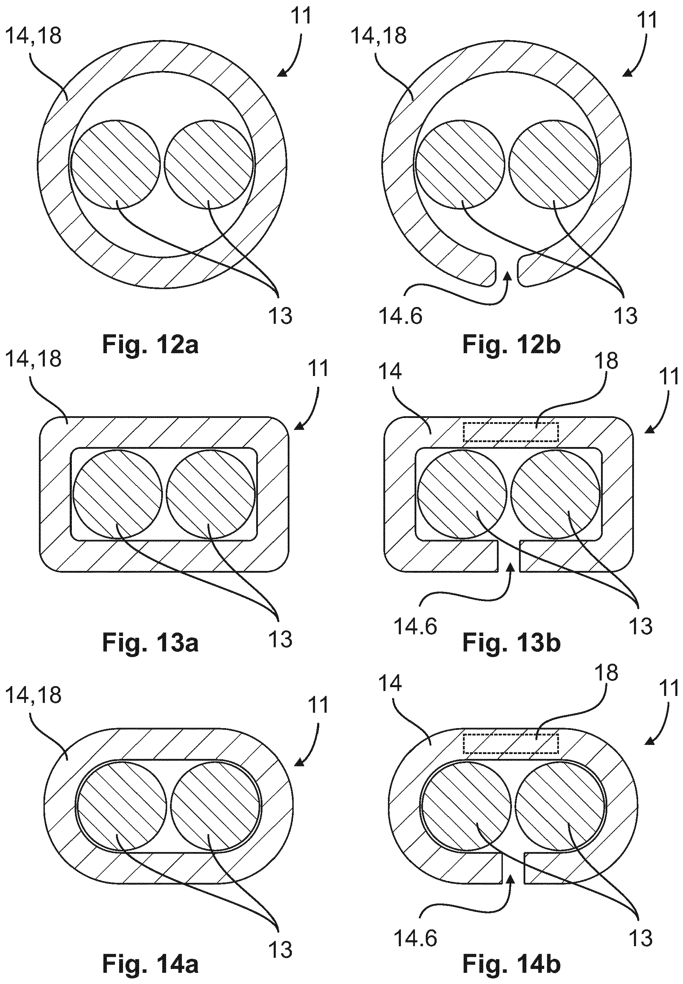

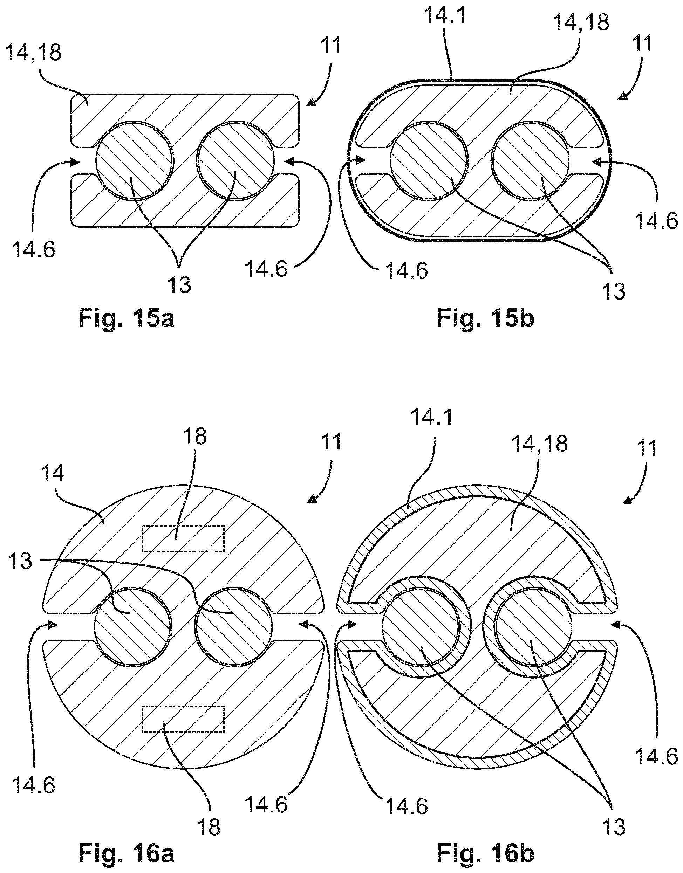

In den folgenden Figuren 12a bis 16b sind diverse Schnitte A-A durch weitere Varianten von erfindungsgemäßen Sensorelementen 11, 12 dargestellt. In den Figuren 12a bis 14a wird jeweils der Draht 13 durch den in sich geschlossenen Querschnitt vom Trägerelement 14 durchgefädelt. Dabei sind die jeweiligen Trägerelemente 14 rohrförmig mit kreisrundem Querschnitt oder rechteckförmigen Querschnitt bzw. ellipsenförmigen Querschnitt ausgestaltet. In den Figuren 12b bis 14b sowie 15a bis 16b weisen die entsprechenden Trägerelemente 14 die bereits mehrfach beschriebenen Befestigungsmittel 14.6 auf, um den Draht 13 am Trägerelement 14 zu sichern. Das Besondere an dem dargestellten Befestigungsmittel 14.6 in den Figuren 12b, 13b, 14b besteht darin, dass es den Draht bei der Hin- und Rückführung gleichzeitig einklemmt, so dass nur ein Befestigungsmittel 14.6 für den hin- und zurückgeführten Draht 13 notwendig ist. Bei den Ausführungsbeispielen aus den Figuren 12a bis 16b kann jeweils der elektrisch leitende Kern 18 das vollständige Trägerelement 14 bilden. Dieses ist z. B. möglich, wenn für den elektrisch leitenden Kern 18 ein elektrisch leitendes Polymer verwendet wird, wie bereits beschrieben. Rein optional ist es denkbar und in den Figuren 13b, 14b sowie 16a gezeigt, dass zumindest ein zusätzlicher oder ersetzender elektrisch leitender Kern 18 vorhanden ist. In den Figuren 15b und 16b wird das Trägerelement 14, welches vollständig aus dem elektrisch leitenden Kern 18 gebildet ist, mit einer elektrisch isolierten Schutzhülle 14.1 bzw. Schrumpfschlauch 14.1 umhüllt. Die Fertigung des erfindungsgemäßen Sensorelements 11, 12 ist bei den Ausführungsbeispielen aus den Figuren 12b, 13b, 14b, 15a, 15b, 16a und 16b besonders einfach, da der Draht 13 nur in das jeweilige Befestigungsmittel 14.6 hineingedrückt werden muss. In diesem Befestigungsmittel 14.6 ist der Draht 13 linear am Trägerelement 14 gehalten. Damit ist eine besonders einfache Herstellung des Trägerelements 14 bzw. des jeweiligen Sensorelements 11, 12 möglich. In den Figuren 15a, 15b, 16a und 16b ist für die Hinführung des Drahtes 13 und die Rückführung des Drahts 13 jeweils ein Befestigungsmittel 14.6 vorgesehen, in die der Draht 13 jeweils hineingedrückt werden muss.

Die in den Figuren 12a bis 16b dargestellten Ausführungsbeispiele der Sensorelemente 11, 12 weisen den Vorteil auf, dass sie einerseits hoch flexibel sind und somit auf besonders einfache Art und Weise am Kraftfahrzeug befestigt werden können und andererseits besonders einfach herstellbar sind. Dieses ist besonders dann besonders einfach, wenn das Trägerelement 14 überwiegend aus einem elektrisch leitenden Kern 18 besteht, der wiederum ein Material aus elektrisch leitendem Polymer aufweist.

Aus den zuvor genannten Figuren ergibt sich auch, dass zahlreiche Kombinationen der dargestellten technischen Merkmale möglich sind. So ist die Querschnittsfläche des Trägerelements 14 nicht auf die dargestellten Formen der Querschnitte beschränkt. Auch kann jedes der dargestellten Ausführungsbeispiele mit einer zusätzlichen Schutzhülle 14.1 umhüllt sein. Diese Schutzhülle 14.1 kann auch aus einem Schrumpfschlauch oder einer Beschichtung bestehen.

Es sei an dieser Stelle erwähnt, dass selbstverständlich die erfindungsgemäße Sensoreinheit 10 auch zum Öffnen der Seitentüren oder der Motorraumklappe oder des Tankdeckels oder dergleichen verwendet werden kann. Anstelle des dargestellten Sensorelements 11 kann auch das Sensorelement 12 Verwendung finden und umgekehrt. Auch ist eine beliebige Kombination der unterschiedlichen Ausführungsbeispiele der Sensorelemente 11 und 12 bei einer Sensoreinheit 10 realisierbar.

### Bezugszeichenliste

- 10: Sensoreinheit
- 11: erstes Sensorelement
- 12: zweites Sensorelement
- 13: Draht
- 13.1: Isolation
- 13.2: Seele
- 13.3: erstes Ende
- 13.4: zweites Ende
- 13.5: Abschirmung
- 14: Trägerelement
- 14.1: Grundplatte / Schutzhülle
- 14.2: Ebene
- 14.3: Scharnier, Filmscharnier
- 14.4: Deckelelement
- 14.5: Rastmittel
- 14.6: Befestigungsmittel, Klemme
- 14.6a: Steg / Hals
- 14.6b: Haken / pilzkopfartiger Kopf
- 14.7: Trennfuge
- 14.8: Verbindungssteg
- 14.9: Ausnehmung
- 14.10: Rippe
- 14.11: Breite
- 14.12: Länge
- 14.13: Haltemittel
- 14.14: Knickschutz
- 14.15: Längsachse
- 14.16: Höhe
- 14.17: Buckel, Materialansammlung
- 15: Längsrichtung
- 16: Abschirmelement
- 17: Stecker
- 17.1: Kontakt von 11
- 17.2: Kontakt von 12
- 17.3: Kontakt von 13.5
- 18: Kern
- 18.1: Mittelsteg
- 18.2: Zinken
- 18.3: Zwischenraum
- 18.4: Sollbruchstelle

- 19: Kappe
- 19.1: Zugentlastung

- 100: Fahrzeug
- 101: Klappe oder dergleichen
- 102: Stellelement
- 110: Sicherheitssystem

## Patentansprüche

1. Sensoreinheit (10) zum berührungslosen Betätigen eines Stellelementes (102), insbesondere einer Klappe (101) oder dergleichen eines Fahrzeuges (100),
mit zumindest einem kapazitiven Sensorelement (11, 12), wobei das Sensorelement (11, 12) einen Draht (13) aufweist, der an einem Trägerelement (14) angeordnet ist,
wobei
das Trägerelement (14) zumindest einen elektrisch leitenden Kern (18) aufweist, wobei der elektrisch leitende Kern (18) folienartig ausgestaltet ist, wobei der Draht (13) endlos am Trägerelement (14) angeordnet ist.

2. Sensoreinheit (10) nach Anspruch 1,
**dadurch gekennzeichnet,**
**dass** der Draht (13) im Wesentlichen parallel zu Längsrichtung (15) des Trägerelements (14) verläuft,
und/oder
**dass** beide Enden (13.3, 13.4) des Drahtes (13) an einem Ende des Trägerelementes (14), insbesondere hervorstehend vorgesehen sind,
und/oder dass der Draht (13) zumindest im Bereich des Trägerelements (14) mit einer elektrischen Isolation (13.1) versehen ist,
wobei insbesondere die Isolation (13.1) des Drahtes (13) bis zum einem Stecker (17) der Sensoreinheit (10) reicht
und/oder dass der Draht (13) im Wesentlichen in einer Ebene (14.2) am Trägerelement (14) angeordnet ist.

3. Sensoreinheit (10) nach einem der vorhergehenden Ansprüche,
**dadurch gekennzeichnet,**
**dass** ein Stück des Drahts (13), der direkt am Trägerelement (14) angeordnet ist, eine Länge aufweist, die im Wesentlichen doppelt so lang ist wie eine Länge (14.12) des Trägerelements (14) und/oder
**dass** der Draht (13) am Trägerelement (14) U-förmig angeordnet ist.

4. Sensoreinheit (10) nach einem der vorhergehenden Ansprüche,
**dadurch gekennzeichnet,**
**dass** der elektrisch leitende Kern (18) des Trägerelements (14) oder das Trägerelement (14) selbst im Wesentlichen von einer Schutzhülle (14.1) umgeben ist, wobei insbesondere die Schutzhülle (14.1) eine elektrische Isolation aufweist, und
wobei insbesondere der Draht (13) galvanisch getrennt vom Kern (18) des Trägerelements (14) angeordnet ist
und/oder dass der elektrisch leitende Kern (18) großflächig ausgestaltet ist und/oder dass der elektrisch leitende Kern (18) selbst das Trägerelement (14) bildet,
und/oder dass der Kern (18) eine Dicke kleiner als 5 mm, bevorzugt kleiner als 2 mm besonders bevorzugt kleiner als 0,5 mm aufweist,
und/oder dass der elektrisch leitende Kern (18) sich im Wesentlichen über die Länge (14.12) des Trägerelements (14) erstreckt und/oder
der elektrisch leitende Kern (18) und/oder das Trägerelements (14) über Trennstellen und/oder Sollbruchstellen (18.4) verfügt.

5. Sensoreinheit (10) nach einem der vorhergehenden Ansprüche,
**dadurch gekennzeichnet,**
**dass** der elektrisch leitende Kern (18) kammartig, insbesondere doppel kammartig ausgestaltet ist,
und/oder dass der elektrisch leitende Kern (18) Edelstahl, Kupfer, Messing und/oder leitfähige Polymere aufweist.

6. Sensoreinheit (10) nach einem der vorhergehenden Ansprüche,
**dadurch gekennzeichnet,**
**dass** am Trägerelement (14) Befestigungsmittel (14.6) angeordnet sind, durch die der Draht (13) am Trägerelement (14) insbesondere formschlüssig fixiert ist,
wobei insbesondere die Schutzhülle (14.1) des Trägerelementes (14) einteilig mit den Befestigungsmitteln (14.6) ausgestaltet ist,
und/oder dass am Trägerelement (14) Befestigungsmittel (14.6) vorgesehen sind, die zur Führung, insbesondere Umlenkung des Drahtes (13) dienen,
wobei insbesondere ein Befestigungsmittel (14.6) über einen Steg (14.6a) und einen Haken (14.6b) verfügt.

7. Sensoreinheit (10) nach einem der vorhergehenden Ansprüche,
**dadurch gekennzeichnet,**
**dass** die Befestigungsmittel (14.6) den Draht (13) im Wesentlichen umgreifen,
so dass der Draht (13) insbesondere geschützt vor äußeren Einflüssen am Trägerelement (14) angeordnet ist.

8. Sensoreinheit (10) nach einem der vorhergehenden Ansprüche,
**dadurch gekennzeichnet,**
**dass** das Trägerelement (14) den Draht (13) zumindest teilweise oder vollständig umhüllt,
wobei insbesondere das Trägerelement (14) eine äußere, kreisförmige oder rechteckförmige Querschnittsfläche aufweist.

9. Sensoreinheit (10) nach einem der vorhergehenden Ansprüche,
**dadurch gekennzeichnet,**
**dass** zumindest ein Ende vom Trägerelement (14) mit einer Kappe (19) umschlossen ist,
wobei insbesondere an der Kappe (19) eine Zugentlastung (19.1) für den Draht (13) vorgesehen ist.

10. Sensoreinheit (10) nach einem der vorhergehenden Ansprüche,
**dadurch gekennzeichnet,**
**dass** das Trägerelement (14) zumindest eine Grundplatte (14.1) aufweist, aus der insbesondere die Befestigungsmittel (14.6) zur Fixierung des Drahtes (13) herausragen,
wobei insbesondere die Grundplatte (14.1) mit dem Draht (13) durch wenigstens ein Deckelelement (14.4) wenigstens bereichsweise abdeckbar ist, wobei vorteilhafterweise das Deckelelement (14.4) stoffschlüssig mit der Grundplatte (14.1) verbunden ist.

11. Sensoreinheit (10) nach einem der vorhergehenden Ansprüche,
**dadurch gekennzeichnet,**
**dass** das Sensorelement (11, 12) mit seinem Trägerelement (14) und dem Draht (13) insgesamt flexibel, insbesondere in Längsrichtung (15), ausgestaltet ist,
und/oder dass zumindest zwei kapazitive Sensorelemente (11, 12) mit einem gemeinsamen Stecker (17) eine Sensoreinheit (10) bilden.

12. Sensoreinheit (10) nach einem der vorhergehenden Ansprüche,
**dadurch gekennzeichnet,**
**dass** das Trägerelement (14) als Spritzgusselement aus einem stabilen Kunststoff ausgebildet ist,
wobei insbesondere über die Länge (14.12) des Trägerelementes (14) wenigstens eine Trennfuge (14.7) mit zumindest einem Verbindungssteg (14.8) angeordnet ist, um eine Flexibilität insbesondere in Längsrichtung (15) zu erreichen.

13. Sensoreinheit (10) nach einem der vorhergehenden Ansprüche,
**dadurch gekennzeichnet,**
**dass** am Trägerelement (14) Haltemittel (14.13) angeordnet sind, womit der Sensor (11, 12) am Fahrzeug (100) befestigbar ist,
wobei insbesondere die Haltemittel (14.13) eine stoffschlüssige und/oder formschlüssige Befestigung ermöglichen.

14. Sicherheitssystem (110) zum insbesondere berührungslosen Öffnen und/oder Schließen einer Klappe (101) eines Fahrzeuges (100) oder dergleichen, mit zumindest einer Sensoreinheit (10) gemäß einem der vorhergehenden Ansprüche.

15. Verfahren zu Herstellung einer Sensoreinheit (10) zum berührungslosen Betätigen eines Stellelementes (102), insbesondere einer Klappe (101) oder dergleichen eines Fahrzeuges (100), mit zumindest einem kapazitiven Sensorelement (11, 12) bei der ein elektrisch leitender Kern im Wesentlichen von einem Trägerelement (14), welches insbesondere elektrisch isolierend ist, umhüllt wird,
wobei ein Draht (13) endlos am Trägerelement (14) fixiert wird,
wobei eine Sensoreinheit (10) gemäß einem der vorhergehenden Ansprüche hergestellt wird.

## Claims

1. Sensor unit (10) for contactless actuation of an actuator (102), in particular a flap (101) or the like of a vehicle (100),
comprising at least one capacitive sensor element (11, 12), wherein the sensor element (11, 12) comprises a wire (13) arranged on a carrier element (14), wherein the carrier element (14) comprises at least one electrically conductive core (18), wherein the electrically conductive core (18) is configured as a foil, wherein the wire (13) is arranged continuously on the carrier element (14).

2. Sensor unit (10) according to claim 1,
**characterized in that**
the wire (13) extends substantially parallel to the longitudinal direction (15) of the carrier element (14),
and/or that both ends (13.3, 13.4) of the wire (13) are provided at one end of the carrier element (14), in particular so as to protrude,
and/or that the wire (13) is provided with electrical insulation (13.1) at least in the region of the carrier element (14),
wherein, in particular, the insulation (13.1) of the wire (13) extends to a connector (17) of the sensor unit (10)
and/or that the wire (13) is arranged substantially in a plane (14.2) on the carrier element (14).

3. Sensor unit (10) according to one of the preceding claims,
**characterized in that**
a section of the wire (13) arranged directly on the carrier element (14) has a length that is substantially twice as long as a length (14.12) of the carrier element (14) and/or that the wire (13) is arranged in a U-shape on the carrier element (14).

4. Sensor unit (10) according to one of the preceding claims,
**characterized in that**
the electrically conductive core (18) of the carrier element (14) or the carrier element (14) itself is substantially surrounded by a protective sheath (14.1),
wherein, in particular, the protective sheath (14.1) provides electrical insulation, and
wherein, in particular, the wire (13) is arranged in galvanic isolation from the core (18) of the carrier element (14)
and/or that the electrically conductive core (18) has a large surface area and/or
that the electrically conductive core (18) itself forms the carrier element (14),
and/or that the core (18) has a thickness of less than 5 mm, preferably less than 2 mm, and most preferably less than 0.5 mm,
and/or that the electrically conductive core (18) extends substantially over the length (14.12) of the carrier element (14) and/or
the electrically conductive core (18) and/or the carrier element (14) has separation points and/or predetermined breaking points (18.4).

5. Sensor unit (10) according to one of the preceding claims,
**characterized in that**
the electrically conductive core (18) is designed in a comb-like, in particular double-comb-like, configuration,
and/or that the electrically conductive core (18) comprises stainless steel, copper, brass, and/or conductive polymers.

6. Sensor unit (10) according to one of the preceding claims,
**characterized in that**
fastening means (14.6) are arranged on the carrier element (14), by means of which the wire (13) is fixed to the carrier element (14), in particular by positive locking,
wherein, in particular, the protective sheath (14.1) of the carrier element (14) is formed integrally with the fastening means (14.6),
and/or that fastening means (14.6) are provided on the carrier element (14) which serve to guide, in particular to deflect, the wire (13),
wherein, in particular, a fastening means (14.6) comprises a web (14.6a) and a hook (14.6b).

7. Sensor unit (10) according to one of the preceding claims,
**characterized in that**
the fastening means (14.6) substantially encircle the wire (13),
so that the wire (13) is arranged on the carrier element (14) in a manner that is, in particular, protected from external influences.

8. Sensor unit (10) according to one of the preceding claims,
**characterized in that**
the carrier element (14) at least partially or completely encloses the wire (13),
wherein, in particular, the carrier element (14) has an outer circular or rectangular cross-sectional area.

9. Sensor unit (10) according to one of the preceding claims,
**characterized in that**
at least one end of the carrier element (14) is enclosed by a cap (19),
wherein, in particular, a strain relief (19.1) for the wire (13) is provided on the cap (19).

10. Sensor unit (10) according to one of the preceding claims,
**characterized in that**
the carrier element (14) comprises at least one base plate (14.1) from which, in particular, the fastening means (14.6) for securing the wire (13) protrude,
wherein, in particular, the base plate (14.1) together with the wire (13) can be covered, at least in some areas, by at least one cover element (14.4), wherein the cover element (14.4) is advantageously connected to the base plate (14.1) by material bonding.

11. Sensor unit (10) according to one of the preceding claims,
**characterized in that**
the sensor element (11, 12), together with its carrier element (14) and the wire (13), is designed to be flexible as a whole, particularly in the longitudinal direction (15),
and/or that at least two capacitive sensor elements (11, 12) form a sensor unit (10) with a common connector (17).

12. Sensor unit (10) according to one of the preceding claims,
**characterized in that**
the carrier element (14) is formed as an injection-molded part made of a stable plastic,
wherein, in particular, along the length (14.12) of the carrier element (14), at least one parting line (14.7) with at least one connecting web (14.8) is arranged to achieve flexibility, particularly in the longitudinal direction (15).

13. Sensor unit (10) according to one of the preceding claims,
**characterized in that**
retaining means (14.13) are arranged on the carrier element (14), by means of which the sensor (11, 12) can be fastened to the vehicle (100),
wherein, in particular, the retaining means (14.13) enable a fastening by material bonding and/or a form-locking fastening.

14. Safety system (110) for, in particular, contactless opening and/or closing of a flap (101) of a vehicle (100) or the like, comprising at least one sensor unit (10) according to one of the preceding claims.

15. Method for manufacturing a sensor unit (10) for contactless actuation of an actuator (102), in particular a flap (101) or the like of a vehicle (100), comprising at least one capacitive sensor element (11, 12), in which an electrically conductive core is substantially enclosed by a carrier element (14), which is in particular electrically insulating, wherein a wire (13) is fixed continuously to the carrier element (14), wherein a sensor unit (10) according to one of the preceding claims is manufactured.

## Revendications

1. Unité de capteur (10) destinée à l'actionnement sans contact d'un élément de réglage (102), en particulier d'un clapet (101) ou similaire d'un véhicule (100),
comprenant au moins un élément capteur capacitif (11, 12), l'élément capteur (11, 12) comportant un fil (13) disposé sur un élément de support (14), l'élément de support (14) comportant au moins un noyau électriquement conducteur (18), le noyau électriquement conducteur (18) étant réalisé sous forme de feuille, le fil (13) étant disposé sans fin sur l'élément de support (14).

2. Unité de capteur (10) selon la revendication 1,
**caractérisée en ce que**
le fil (13) s'étend essentiellement parallèlement à la direction longitudinale (15) de l'élément de support (14),
et/ou que les deux extrémités (13.3, 13.4) du fil (13) sont prévues à une extrémité de l'élément de support (14), en particulier de manière saillante,
et/ou **en ce que** le fil (13) est muni d'une isolation électrique (13.1) au moins dans la zone de l'élément de support (14),
l'isolation (13.1) du fil (13) s'étendant notamment jusqu'à une fiche (17) de l'unité de capteur (10)
et/ou que le fil (13) est disposé essentiellement dans un plan (14.2) sur l'élément de support (14).

3. Unité de capteur (10) selon l'une des revendications précédentes,
**caractérisée en ce qu'**
un tronçon du fil (13) disposé directement sur l'élément de support (14) présente une longueur qui est sensiblement le double d'une longueur (14.12) de l'élément de support (14) et/ou
**en ce que** le fil (13) est disposé en forme de U sur l'élément de support (14).

4. Unité de capteur (10) selon l'une des revendications précédentes,
**caractérisée en ce que**
le noyau électriquement conducteur (18) de l'élément de support (14) ou l'élément de support (14) lui-même est essentiellement entouré d'une gaine de protection (14.1),
dans laquelle, en particulier, la gaine de protection (14.1) présente une isolation électrique, et
dans laquelle, en particulier, le fil (13) est disposé de manière galvaniquement isolée du noyau (18) de l'élément de support (14)
et/ou que le noyau électriquement conducteur (18) présente une grande surface et/ou
que le noyau électriquement conducteur (18) forme lui-même l'élément de support (14),
et/ou que le noyau (18) présente une épaisseur inférieure à 5 mm, de préférence inférieure à 2 mm, de manière particulièrement préférée inférieure à 0,5 mm,
et/ou que le noyau électriquement conducteur (18) s'étend essentiellement sur la longueur (14.12) de l'élément de support (14) et/ou
que le noyau électriquement conducteur (18) et/ou l'élément de support (14) comporte des points de séparation et/ou des points de rupture prédéterminés (18.4).

5. Unité de capteur (10) selon l'une des revendications précédentes,
**caractérisée en ce que**
le noyau électriquement conducteur (18) est conçu en forme de peigne, en particulier en forme de double peigne,
et/ou **en ce que** le noyau électriquement conducteur (18) comprend de l'acier inoxydable, du cuivre, du laiton et/ou des polymères conducteurs.

6. Unité de capteur (10) selon l'une des revendications précédentes,
**caractérisée en ce que**
des moyens de fixation (14.6) sont disposés sur l'élément de support (14), par lesquels le fil (13) est fixé à l'élément de support (14), en particulier par complémentarité de forme,
la gaine de protection (14.1) de l'élément de support (14) étant notamment réalisée d'un seul tenant avec les moyens de fixation (14.6),
et/ou **en ce que** des moyens de fixation (14.6) sont prévus sur l'élément de support (14), qui servent au guidage, en particulier au renvoi, du fil (13),
un moyen de fixation (14.6) comportant notamment une entretoise (14.6a) et un crochet (14.6b).

7. Unité de capteur (10) selon l'une des revendications précédentes,
**caractérisée en ce que**
les moyens de fixation (14.6) entourent sensiblement le fil (13),
de sorte que le fil (13) est disposé sur l'élément de support (14) de manière notamment protégée contre les influences extérieures.

8. Unité de capteur (10) selon l'une des revendications précédentes,
**caractérisée en ce que**
l'élément de support (14) enveloppe le fil (13) au moins partiellement ou complètement,
l'élément de support (14) présentant notamment une surface de section transversale extérieure circulaire ou rectangulaire.

9. Unité de capteur (10) selon l'une des revendications précédentes,
**caractérisée en ce qu'**
au moins une extrémité de l'élément de support (14) est entourée d'un capuchon (19),
un dispositif de décharge de traction (19.1) pour le fil (13) étant notamment prévu sur le capuchon (19).

10. Unité de capteur (10) selon l'une des revendications précédentes,
**caractérisée en ce que**
l'élément de support (14) comporte au moins une plaque de base (14.1) de laquelle dépassent notamment les moyens de fixation (14.6) destinés à fixer le fil (13),
la plaque de base (14.1) avec le fil (13) pouvant être recouverte, au moins par endroits, par au moins un élément de recouvrement (14.4), l'élément de recouvrement (14.4) étant de préférence relié par adhérence de matière à la plaque de base (14.1).

11. Unité de capteur (10) selon l'une des revendications précédentes,
**caractérisée en ce que**
l'élément capteur (11, 12) est conçu, avec son élément de support (14) et le fil (13), de manière globalement flexible, en particulier dans le sens longitudinal (15),
et/ou **en ce qu'**au moins deux éléments capteurs capacitifs (11, 12) forment, avec une fiche commune (17), une unité de capteur (10).

12. Unité de capteur (10) selon l'une des revendications précédentes,
**caractérisée en ce que**
l'élément de support (14) est réalisé sous la forme d'un élément moulé par injection en une matière plastique stable,
au moins une ligne de joint (14.7) avec au moins une nervure de liaison (14.8) étant disposée, en particulier sur la longueur (14.12) de l'élément de support (14), afin d'obtenir une flexibilité, en particulier dans le sens longitudinal (15).

13. Unité de capteur (10) selon l'une des revendications précédentes,
**caractérisée en ce que**
des moyens de retenue (14.13) sont disposés sur l'élément de support (14), grâce auxquels le capteur (11, 12) peut être fixé au véhicule (100),
les moyens de retenue (14.13) permettant notamment une fixation par adhérence et/ou par complémentarité de forme.

14. Système de sécurité (110) destiné notamment à l'ouverture et/ou à la fermeture sans contact d'un clapet (101) d'un véhicule (100) ou similaire, comprenant au moins une unité de capteur (10) selon l'une des revendications précédentes.

15. Procédé de fabrication d'une unité de capteur (10) destinée à l'actionnement sans contact d'un élément de réglage (102), en particulier d'un clapet (101) ou similaire d'un véhicule (100), comprenant au moins un élément de capteur capacitif (11, 12) dans lequel un noyau électriquement conducteur est essentiellement enveloppé par un élément de support (14), qui est notamment électriquement isolant, un fil (13) étant fixé de manière continue à l'élément de support (14), une unité de capteur (10) selon l'une des revendications précédentes étant fabriquée.
